# EUROPEAN PATENT APPLICATION

(11) **EP 4 738 439 A1**
(43) Date of publication of application: **06.05.2026**
(21) Application number: 24882681.0
(22) Date of filing: 27.09.2024
(51) Int. Cl.: H01L 25/075, H10H 20/841, H10H 20/85, H10H 20/831, H10H 20/851, H10H 20/857, H10H 29/01

(54) **LIGHT-EMITTING DIODE AND DISPLAY MODULE COMPRISING SAME**

(30) Priority: 24.10.2023 KR 20230143166
(71) Applicant: Samsung Electronics Co., Ltd., Suwon-si, Gyeonggi-do 16677 (KR)
(72) Inventor: LEE, Jinwoong, Suwon-si Gyeonggi-do 16677 (KR); YOO, Sunghyun, Suwon-si Gyeonggi-do 16677 (KR); KIM, Hyunkyung, Suwon-si Gyeonggi-do 16677 (KR); LEE, Kyehoon, Suwon-si Gyeonggi-do 16677 (KR)
(74) Representative: Appleyard Lees IP LLP
(86) International application number: PCT/KR2024/014810
(87) International publication number: WO 2025/089652

(57) **Abstract**

A light-emitting diode is disclosed. The light-emitting diode comprises: a metal pad; a first sub-pixel provided on the metal pad and emitting light of a first color; a second sub-pixel emitting light of a second color different from the first color; and a third sub-pixel emitting light of a third color different from the first color and the second color.

## Description

### [Technical Field]

The present disclosure relates to a light-emitting diode and a display module comprising the same.

### [Background Art]

The display panel may include a thin film transistor (TFT) layer having a plurality of TFTs and a plurality of light-emitting diodes mounted on the TFT layer. The plurality of light-emitting diodes may express various colors while being operated in pixel units or sub-pixel units. An operation of each pixel or each sub-pixel may be controlled by the plurality of TFTs. Each light-emitting diode may emit various colors, for example, red, green, and blue.

### [Disclosure of Invention]

### [Solution to Problem]

According to at least one embodiment of the present disclosure, provided is a light-emitting diode including: a metal pad; a first sub-pixel, arrangeable on the metal pad, configured to emit light of a first color; a second sub-pixel configured to emit light of a second color different from the light of the first color; and a third sub-pixel configured to emit light of a third color different from the light of the first color from the first sub-pixel and the light of the second color from the second sub-pixel.

The first sub-pixel, the second sub-pixel, and the third sub-pixel may be arranged parallel to one another along a horizontal direction. The light-emitting diode may further include a first partition to be disposed between the first sub-pixel and the second sub-pixel, and a second partition to be disposed between the second sub-pixel and the third sub-pixel.

The first partition and the second partition may respectively include a distributed Bragg reflector (DBR) structure.

The first sub-pixel, the second sub-pixel, and the third sub-pixel may be electrically insulated, respectively, from the metal pad through an insulating layer.

The first sub-pixel, the second sub-pixel, and the third sub-pixel may be electrically connected in series.

The first sub-pixel, the second sub-pixel, and the third sub-pixel may repsectively include an anode device electrode and a cathode device electrode. The cathode device electrode of the first sub-pixel may be electrically connected to the anode device electrode of the second sub-pixel. The cathode device electrode of the second sub-pixel may be electrically connected to the anode device electrode of the third sub-pixel.

The cathode device electrode of the first sub-pixel and the anode device electrode of the second sub-pixel may be integrally formed. The cathode device electrode of the second sub-pixel and the anode device electrode of the third sub-pixel may be integrally formed.

The cathode device electrode of the third sub-pixel may be electrically connected to the metal pad.

The first sub-pixel, the second sub-pixel, and the third sub-pixel may respectively include an anode device electrode and a cathode device electrode. The cathode device electrode of the first sub-pixel, the cathode device electrode of the second sub-pixel, and the cathode device electrode of the third sub-pixel may respectively be electrically connected to the metal pad.

The cathode device electrode of the first sub-pixel and the anode device electrode of the second sub-pixel may be integrally formed. The cathode device electrode of the second sub-pixel and the anode device electrode of the third sub-pixel may be integrally formed.

One of the first sub-pixel, the second sub-pixel, and the third sub-pixel may further include a color conversion layer. The color conversion layer may include quantum dots or nano phosphors.

The first sub-pixel may include a semiconductor layer configured to emit light of the first color. The second sub-pixel may include a semiconductor layer configured to emit light of the first color, and a first color conversion layer stacked on the semiconductor layer of the second sub-pixel and excited by light of the first color from the second sub-pixel to emit light of the second color different from light of the first color. The third sub-pixel may include a semiconductor layer configured to emit light of the first color, and a second color conversion layer stacked on the semiconductor layer of the third sub-pixel and excited by light of the first color from the third sub-pixel to emit light of the third color different from light of the first color and the second color.

The second sub-pixel and the third sub-pixel may be stacked on the first sub-pixel at an interval therebetween. Light emitted from the first sub-pixel may be projected into a space between the second sub-pixel and the third sub-pixel.

The first sub-pixel may include a first transparent electrode layer stacked on a light-emitting surface of the first sub-pixel, a distributed Bragg reflector (DBR) layer covering a side surface of the first sub-pixel and a portion of the first transparent electrode layer, and an adhesive layer formed of a conductive metal material, disposed below the first sub-pixel, and metallurgically bonded to the metal pad. The second sub-pixel and the third sub-pixel may be respectively stacked on the DBR layer.

The second sub-pixel and the third sub-pixel may respectively include an anode device electrode and a cathode device electrode. The cathode device electrode of the second sub-pixel and the cathode device electrode of the third sub-pixel may be electrically connected to the metal pad, respectively.

One of the first sub-pixel, the second sub-pixel, and the third sub-pixel may further include a color conversion layer. The color conversion layer may include quantum dots or nano phosphors.

The first sub-pixel may include a semiconductor layer configured to emit light of the first color, and a first color conversion layer stacked on the semiconductor layer of the first sub-pixel and excited by light of the first color from the first sub-pixel to emit light of the second color different from light of the first color. The second sub-pixel may include a semiconductor layer configured to emit light of the first color. The third sub-pixel may include a semiconductor layer configured to emit light of the first color, and a second color conversion layer stacked on the semiconductor layer of the third sub-pixel and excited by light of the first color from the third sub-pixel to emit light of the third color different from light of the first color and the second color.

The first sub-pixel may include a semiconductor layer configured to emit light of the first color. The second sub-pixel may include a semiconductor layer configured to emit light of the first color, and a first color conversion layer stacked on the semiconductor layer of the second sub-pixel and excited by light of the first color from the second sub-pixel to emit light of the second color different from light of the first color. The third sub-pixel may include a semiconductor layer configured to emit light of the first color, and a second color conversion layer stacked on the semiconductor layer of the third sub-pixel and excited by light of the first color from the third sub-pixel to emit light of the third color different from light of the first color and the second color.

The first sub-pixel may include a semiconductor layer configured to emit light of the first color. The second sub-pixel may include a semiconductor layer configured to emit light of the second color. The third sub-pixel may include a semiconductor layer configured to emit light of the second color, and a color conversion layer stacked on the semiconductor layer of the third sub-pixel and excited by light of the second color from the third sub-pixel to emit light of the third color different from light of the first color and the second color. The color conversion layer may include quantum dots or nano phosphors.

According to at least one embodiment of the present disclosure, provided is a display module including: a substrate; and a plurality of light-emitting diodes arranged on the substrate. The plurality of light-emitting diodes may respectively include a metal pad, a first sub-pixel provided on the metal pad and configured to emit light of a first color, a second sub-pixel configured to emit light of a second color different from the first color, and a third sub-pixel configured to emit light of a third color different from the first color and the second color.

### [Brief Description of Drawings]

FIG. 1 is a view illustrating a display module according to at least one embodiment.
FIG. 2 is a view illustrating an example in which a plurality of light-emitting diodes according to at least one embodiment are arranged in a horizontal direction.
FIG. 3 is a view illustrating an example in which a plurality of light-emitting diodes according to at least one embodiment are arranged on a substrate in a vertical direction
FIG. 4 is a perspective view illustrating a light-emitting diode according to at least one embodiment.
FIG. 5 is a cross-sectional view illustrating the light-emitting diode according to at least one embodiment.
FIG. 6 is a circuit diagram schematically illustrating connections between substrate electrodes and the light-emitting diode according to at least one embodiment illustrated in FIG. 5.
FIG. 7 is a cross-sectional view illustrating a light-emitting diode according to at least one embodiment.
FIG. 8 is a circuit diagram schematically illustrating connections between substrate electrodes and the light-emitting diode according to at least one embodiment illustrated in FIG. 7.
FIG. 9 is a cross-sectional view illustrating a light-emitting diode according to at least one embodiment.
FIG. 10 is a cross-sectional view illustrating a light-emitting diode according to at least one embodiment.
FIG. 11 is a circuit diagram schematically illustrating connections between substrate electrodes and the light-emitting diode according to at least one embodiment illustrated in FIG. 10.
FIG. 12 is a cross-sectional view illustrating a light-emitting diode according to at least one embodiment.
FIG. 13 is a cross-sectional view illustrating a light-emitting diode according to at least one embodiment.
FIG. 14 is a cross-sectional view illustrating a light-emitting diode according to at least one embodiment.
FIGS. 15A, 15B, 15C, and 15D are views illustrating examples in which a light-emitting diode according to at least one embodiment has a light-emitting region partitioned into four parts by partitions.
FIGS. 16A, 16B, 16C, 16D, and 16E are views illustrating examples in which a light-emitting diode according to at least one embodiment has a light-emitting region partitioned into three parts by partitions.
FIG. 17 is a plan view illustrating an example in which light-emitting diodes according to at least one embodiment are arranged on a substrate.
FIG. 18 is a cross-sectional view illustrating the light-emitting diode according to at least one embodiment illustrated in FIG. 17.
FIG. 19 is a cross-sectional view illustrating a light-emitting diode according to at least one embodiment.
FIG. 20 is a flowchart schematically illustrating a manufacturing process of the light-emitting diode according to at least one embodiment illustrated in FIG. 19.
FIGS. 21 to 29 are views illustrating the manufacturing process of the light-emitting diode illustrated in FIG. 19 according to at least one embodiment.
FIG. 30 is a cross-sectional view illustrating a light-emitting diode according to at least one embodiment.
FIG. 31 is a cross-sectional view illustrating a light-emitting diode according to at least one embodiment.
FIG. 32 is a cross-sectional view illustrating a light-emitting diode according to at least one embodiment.
FIG. 33 is a block diagram illustrating a display apparatus according to at least one embodiment.

### [Mode for Invention]

Embodiments described in the present disclosure and configurations shown in the accompanying drawings illustrate only one preferred embodiment, and various modified embodiments may replace the embodiments and drawings of the present disclosure at the time of filing of this application.

Throughout the accompanying drawings of the present disclosure, the same reference numerals or symbols denote parts or components performing substantially the same functions.

Terms used in the specification are used to describe embodiments, and are not intended to restrict and/or limit the disclosed invention. A term of a single number may include its plural number unless explicitly indicated otherwise in the context. Terms such as "include" or "have" used in the specification specify the presence of features, numerals, steps, operations, components, parts mentioned in the specification, or combinations thereof, and do not preclude the presence or addition of one or more other features, numerals, steps, operations, components, parts, or combinations thereof.

Terms including ordinal numbers such as "first" and "second" used in the present disclosure may be used to describe various components. However, the components are not limited by these terms, and these terms are used only to distinguish one component from another. For example, a first component may be referred to as a second component, and similarly, the second component may be referred to as the first component without departing from the scope of the present disclosure. A term "and/or" includes a combination of a plurality of related items or any one of the plurality of related items.

Terms such as "front end," "rear end," "upper portion," "lower portion," "front surface," "rear surface," "upper surface," "lower surface," "upper end," "lower end," "one end," "the other end," "left," and "right" used in the present disclosure are defined based on the drawings. The shapes and positions of respective components are not limited by these terms.

In the present disclosure, a light-emitting diode according to at least one embodiment may emit at least two colors of light from a single body. The light-emitting diode may include a plurality of regions that emit at least two colors of light. For example, the light-emitting diode may include, in a single body, a blue light-emitting region that emits blue light, a green light-emitting region that emits green light, and a red light-emitting region that emits red light.

In the present disclosure, a light-emitting diode according to at least one embodiment may correspond to a single pixel. The single pixel may include a single metal pad and first, second, and third sub-pixels provided on the single metal pad. The single pixel may be formed as a single body having a plurality of sub-pixels. The first, second, and third sub-pixels may emit different colors. Partitions may be disposed between the first and second sub-pixels and between the second and third sub-pixels, respectively. The partition may be formed of an opaque or light-reflective material. The partition may block or reflect light emitted from each sub-pixel toward an adjacent sub-pixel, thereby reducing or minimizing cross talk.

In the present disclosure, a light-emitting diode according to at least one embodiment may have a second sub-pixel and a third sub-pixel stacked on a first sub-pixel. In this case, the first sub-pixel may emit blue light, the second sub-pixel may emit green light, and the third sub-pixel may emit red light.

In the present disclosure, a light-emitting diode according to at least one embodiment may have a second sub-pixel and a third sub-pixel stacked on a first sub-pixel. The first, second, and third sub-pixels may all emit blue light. A green quantum dot layer that emits green light when excited by blue light emitted from the first sub-pixel may be provided between the second sub-pixel and the third sub-pixel. A red quantum dot layer that emits red light when excited by blue light emitted from the third sub-pixel may be provided on an upper surface of the third sub-pixel.

In the present disclosure, a light-emitting diode according to at least one embodiment may have a second sub-pixel and a third sub-pixel stacked on a first sub-pixel. The first, second, and third sub-pixels may all emit blue light. A green quantum dot layer that emits green light when excited by blue light emitted from the second sub-pixel may be provided on an upper surface of the second sub-pixel. A red quantum dot layer that emits red light when excited by blue light emitted from the third sub-pixel may be provided on an upper surface of the third sub-pixel. The blue light emitted from the first sub-pixel may be emitted through an upper surface of the first sub-pixel that is not covered by the second and third sub-pixels.

In the present disclosure, a light-emitting diode according to at least one embodiment may have a second sub-pixel and a third sub-pixel stacked on a first sub-pixel. The first sub-pixel may emit green light, and the second sub-pixel and the third sub-pixel may both emit blue light. A red quantum dot layer that emits red light when excited by blue light emitted from the third sub-pixel may be provided on an upper surface of the third sub-pixel.

A display module according to at least one embodiment described in the present disclosure may include a substrate and the plurality of light-emitting diodes described above arranged on the substrate.

Hereinafter, a light-emitting diode according to at least one embodiment and a display module comprising the same are described with reference to the accompanying drawings.

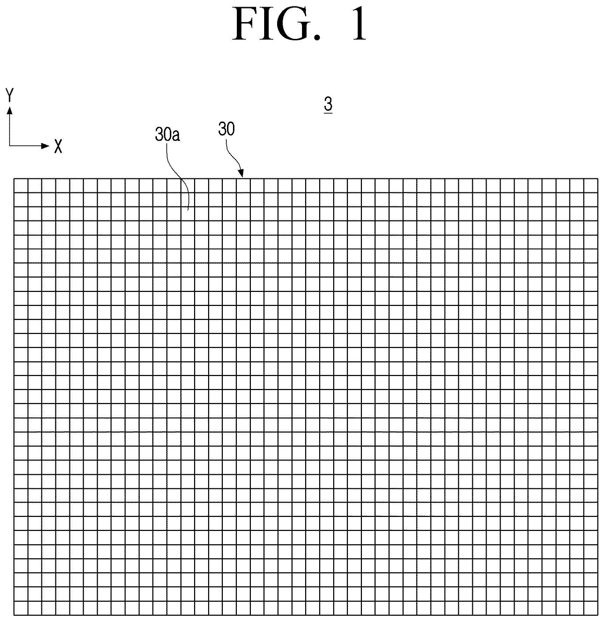

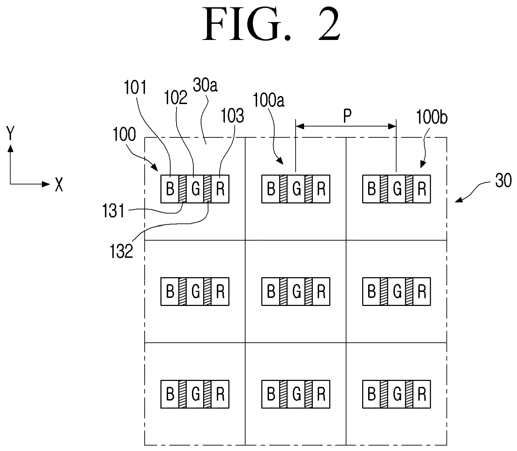

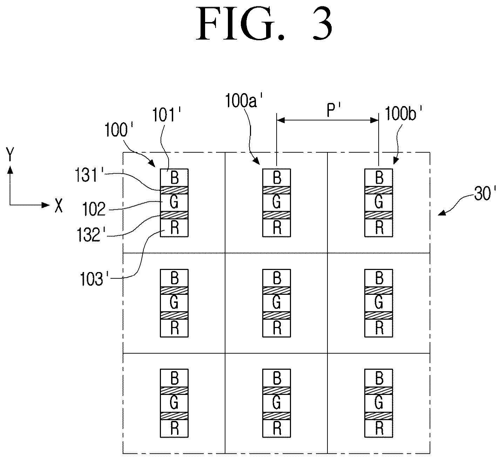

FIG. 1 is a view illustrating a display module according to at least one embodiment. FIG. 2 is a view illustrating an example in which a plurality of light-emitting diodes according to at least one embodiment are arranged on a substrate in a horizontal direction. FIG. 3 is a view illustrating an example in which a plurality of light-emitting diodes according to at least one embodiment are arranged on a substrate in a vertical direction.

Referring to FIGS. 1 and 2, a display module 3 may include a substrate 30 and a plurality of light-emitting diodes 100 arranged on the substrate 30.

The substrate 30 may have a thin film transistor (TFT) layer formed on a front surface thereof, and a power supply circuit for supplying power to the TFT layer, a data driving driver, a gate driving driver, and a timing controller for controlling each driving driver may be disposed on a rear surface thereof.

The TFT layer may include a plurality of TFTs for driving the plurality of light-emitting diodes 100. The TFT layer may be integrally formed on a front surface of the substrate 30, is not limited thereto, and may be manufactured in the form of a separate film and attached to the front surface of the substrate 30. A plurality of substrate electrodes arranged on the TFT layer may be electrically connected to the TFT layer.

The plurality of TFTs included in the TFT layer are not limited to a specific structure or type. For example, the TFT may be implemented as a low temperature polycrystalline (LTPS) TFT, an oxide TFT, a silicon (Si) TFT (poly silicon or a-silicon), an organic TFT, or a graphene TFT. The TFT layer may be applied to the substrate 30 by forming only a P-type (or N-type) metal oxide semiconductor field effect transistor (MOSFET) on a Si wafer in a complementary metal oxide semiconductor (CMOS) process.

A conductive adhesive layer may be stacked on the TFT layer. The conductive adhesive layer may include flux including a plurality of fine metal grains. For example, the conductive adhesive layer may correspond to an anisotropic conductive film including a non-conductive resin in which fine conductive particles are regularly or irregularly arranged. In this case, the non-conductive resin may have a black series color to absorb external light. The external light may correspond to light emitted from natural light or lighting/lightings arranged around the display module. A plurality of device electrodes provided on the plurality of light-emitting diodes 100 and a plurality of substrate electrodes provided on the substrate 30 may be electrically and physically interconnected by the conductive adhesive layer.

Referring to FIG. 2, a plurality of pixel regions 30a forming a substantially lattice-like structure may be provided on the front surface of the substrate 30. A single light-emitting diode 100 may be disposed in each pixel region 30a. The light-emitting diode 100 may emit light of at least different colors in a single body. For example, the single light-emitting diode 100 may include a blue light-emitting region that emits blue light, a green light-emitting region that emits green light, and a red light-emitting region that emits red light. The configuration of the light-emitting diode 100 is described below in detail.

The light-emitting diode 100 may have a first, a second, and a third sub-pixel 101, 102, and 103 arranged parallel to one another in the horizontal direction (e.g., an X-axis direction). The light-emitting diode 100 may correspond to a single pixel including a plurality of sub-pixels. In this case, adjacent light-emitting diodes 100a and 100b may be arranged on the substrate 30 at a predetermined pitch P.

Referring to FIG. 3, a light-emitting diode 100' may have a first, a second, and a third sub-pixel 101', 102', and 103' arranged parallel to one another in the vertical direction (e.g., a Y-axis direction). A first partition 131' may be disposed between the first and second sub-pixels 101' and 102', and a second partition 132' may be disposed between the second and third sub-pixels 102' and 103'. In this case, adjacent light-emitting diodes 100a' and 100b' may be arranged on a substrate 30' at a predetermined pitch P' on the substrate 30'.

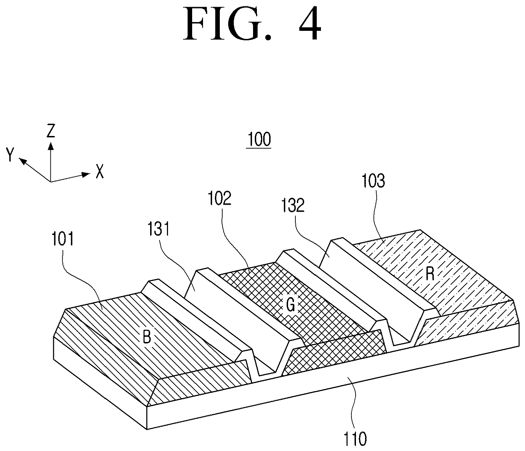

FIG. 4 is a perspective view illustrating the light-emitting diode according to at least one embodiment.

Referring to FIG. 4, the light-emitting diode 100 according to at least one embodiment may include a single metal pad 110, the first sub-pixel 101, the second sub-pixel 102, and the third sub-pixel 103 arranged on a single metal pad 110 to be parallel to one another in one direction (e.g., the X-axis direction), and a first partition 131 disposed between the first and second sub-pixels 101 and 102 and a second partition 132 disposed between the second and third sub-pixels 102 and 103, respectively.

The first, second, and third sub-pixels 101, 102, and 103 may emit light of different colors. For example, the first sub-pixel 101 may emit blue light. The second sub-pixel 102 may emit green light. The third sub-pixel 103 may emit red light. The first sub-pixel 101 may correspond to the blue light-emitting region that emits blue light, the second sub-pixel 102 may correspond to the green light-emitting region that emits green light, and the third sub-pixel 103 may correspond to the red light-emitting region that emits red light.

The first and second sub-pixels 101 and 102 and the third sub-pixel 103 may correspond to semiconductor materials having physical properties different from one another. For example, the first and second sub-pixels 101 and 102 may be gallium nitride (GaN), and the third sub-pixel 103 may be gallium arsenide (GaAs) or gallium phosphide (GaP).

The first and second partitions 131 and 132 may each be formed of a material that is opaque or capable of reflecting light. In addition, the first and second partitions 131 and 132 may each include a distributed Bragg reflector (DBR) structure capable of reflecting light.

The first partition 131 may block or reflect blue light emitted from the first sub-pixel 101 toward the second sub-pixel 102 and may block or reflect green light emitted from the second sub-pixel 102 toward the first sub-pixel 101. Similarly, the second partition 132 may block or reflect green light emitted from the second sub-pixel 102 toward the third sub-pixel 103 and may block or reflect red light emitted from the third sub-pixel 103 toward the second sub-pixel 102. Accordingly, the first and second partitions 131 and 132 may reduce or minimize cross talk that may occur between the adjacent first and second sub-pixels 101 and 102 and between the second and third sub-pixels 102 and 103, respectively.

The light-emitting diode 100 may implement red, green, and blue (RGB) full color from a single body, and it is thus generally unnecessary to separately provide a red light-emitting diode, a blue light-emitting diode, and a green light-emitting diode for each pixel.

Accordingly, when transferring the light-emitting diode 100 according to the present disclosure to the substrate 30, the number of light-emitting diodes per pixel/for each pixel may be reduced from three to one compared to a case in which three red, green, and blue light-emitting diodes are used, thereby decreasing (reducing) an area occupied by a single pixel to about one third. Accordingly, a pixel structure provided on the substrate 30 may be simplified and fabrication of the display module 3 may be facilitated.

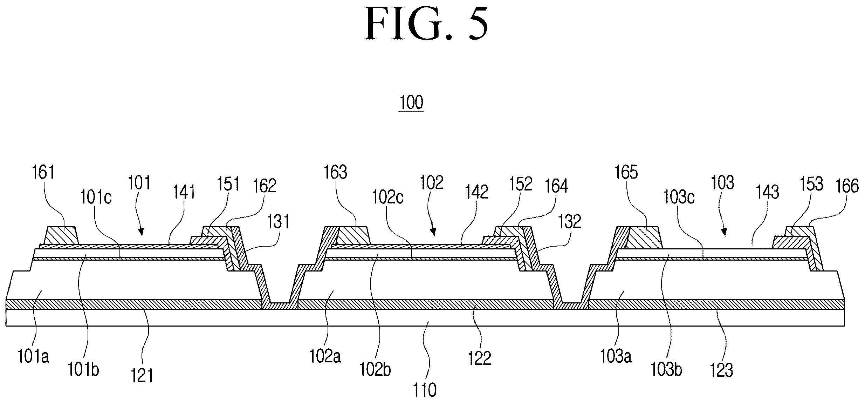

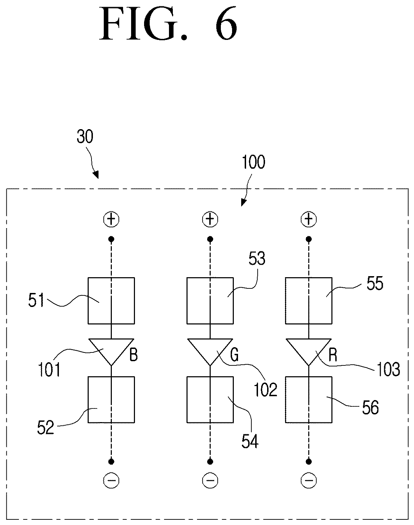

FIG. 5 is a cross-sectional view illustrating the light-emitting diode according to at least one embodiment. FIG. 6 is a circuit diagram schematically illustrating connections between a group of substrate electrodes and the light-emitting diode according to at least one embodiment illustrated in FIG. 5.

Referring to FIG. 5, the light-emitting diode 100 according to at least one embodiment may include the first sub-pixel 101, the second sub-pixel 102, and the third sub-pixel 103 arranged on a single metal pad 110 to be parallel to one another at predetermined intervals. In this case, the first, second, and third sub-pixels 101, 102, and 103 may be attached to an upper surface of the metal pad 110 by using respective adhesive layers 121, 122, and 123. The adhesive layers 121, 122, and 123 may each be formed of an insulating material. Accordingly, the first, second, and third sub-pixels 101, 102, and 103 may each be electrically insulated from the metal pad 110.

The metal pad 110 may be used as a member that physically connects the light-emitting diode 100 to a substrate pad provided on the substrate 30. The substrate pad may be formed of a metal capable of metallic bonding with the metal pad 110 of the light-emitting diode 100. The metal pad 110 may not only be used as a member for physically connecting the light-emitting diode 100 to the substrate 30 but may also be used as a cathode terminal of the light-emitting diode 100 that is electrically and physically connected to a cathode electrode (negative electrode) provided on the substrate 30. An embodiment in which the metal pad 110 is used as a cathode terminal of the light-emitting diode 100 is described below.

The light-emitting diode 100 may further include the first partition 131 disposed between the first sub-pixel 101 and the second sub-pixel 102 and the second partition 132 disposed between the second sub-pixel 102 and the third sub-pixel 103.

A lower side of the first partition 131 may be in contact with a portion of the upper surface of the metal pad 110, a left portion of the first partition 131 may cover a right portion of the first sub-pixel 101, and a right portion of the first partition 131 may cover a left portion of the second sub-pixel 102. Accordingly, the first partition 131 may block or reflect light emitted from the first sub-pixel 101 toward the second sub-pixel 102 and may block or reflect light emitted from the second sub-pixel 102 toward the first sub-pixel 101. The first partition 131 may be deposited on the metal pad 110, the first sub-pixel 101, and the second sub-pixel 102 by a deposition process.

A lower side of the second partition 132 may be in contact with the other portion of the upper surface of the metal pad 110, a left portion of the second partition 132 may cover a right portion of the second sub-pixel 102, and a right portion of the second partition 132 may cover a left portion of the third sub-pixel 103. Accordingly, the second partition 132 may block or reflect light emitted from the second sub-pixel 102 toward the third sub-pixel 103 and may block or reflect light emitted from the third sub-pixel 103 toward the second sub-pixel 102. The second partition 132 may be deposited on the metal pad 110, the second sub-pixel 102, and the third sub-pixel 103 by a deposition process, similarly to the first partition 131.

The first sub-pixel 101 may include a first semiconductor layer 101a in contact with the adhesive layer 121, a second semiconductor layer 101b, and an active layer 101c provided between the first semiconductor layer 101a and the second semiconductor layer 101b. The first semiconductor layer 101a, the second semiconductor layer 101b, and the active layer 101c may be formed by a method such as metal organic chemical vapor deposition (MOCVD), chemical vapor deposition (CVD), or plasma-enhanced chemical vapor deposition (PECVD).

The first semiconductor layer 101a may include, for example, a p-type semiconductor layer. The p-type semiconductor layer may be selected from, for example, gallium nitride (GaN), aluminum nitride (AlN), aluminum gallium nitride (AlGaN), indium gallium nitride (InGaN), indium nitride (InN), indium aluminum gallium nitride (InAlGaN), or aluminum indium nitride (AlInN), and may be doped with a p-type dopant such as magnesium (Mg), zinc (Zn), calcium (Ca), strontium (Sr), or barium (Ba). The second semiconductor layer 101b may include, for example, an n-type semiconductor layer. The n-type semiconductor layer may be selected from, for example, gallium nitride (GaN), aluminum nitride (AlN), aluminum gallium nitride (AlGaN), indium gallium nitride (InGaN), indium nitride (InN), indium aluminum gallium nitride (InAlGaN), or aluminum indium nitride (AlInN), and may be doped with an n-type dopant such as silicon (Si), germanium (Ge), or tin (Sn). The first sub-pixel 101 is not limited to the foregoing configuration, and, for example, the first semiconductor layer 101a may include an n-type semiconductor layer and the second semiconductor layer 101b may include a p-type semiconductor layer.

The active layer 101c refers to a region where electrons and holes recombine, and, as the electrons and the holes recombine, the electrons and the holes transition to a lower energy level and generate light having a corresponding wavelength. The active layer 101c may include a semiconductor material, for example, amorphous silicon or poly crystalline silicon. However, this embodiment is not limited thereto. The active layer 101c may include an organic semiconductor material and may be formed as a single quantum well (SQW) structure or a multi quantum well (MQW) structure. The active layer 101c may emit light in a blue wavelength band.

The first sub-pixel 101 may further include a transparent electrode layer 141 (e.g., an indium tin oxide (ITO)), a passivation layer 151, a first device electrode 161, and a second device electrode 162.

The transparent electrode layer 141 may be provided on the second semiconductor layer 101b of the first sub-pixel 101. The transparent electrode layer 141 may be electrically connected to the second semiconductor layer 101b of the first sub-pixel 101. The passivation layer 151 may partially cover the transparent electrode layer 141 and a left portion of the first sub-pixel 101.

The passivation layer 151 may be partially deposited on the transparent electrode layer 151 and a left portion of the first sub-pixel 101 by using a technique such as atomic layer deposition, e-beam evaporation, sputtering, chemical vapor deposition, or spin coating using an insulating material (e.g., silicon dioxide (SiO₂), aluminum oxide (Al₂O₃), or silicon nitride (SiN)). The passivation layer 151 may physically separate and electrically insulate the transparent electrode layer 141 from the second device electrode 162 of the first sub-pixel 101. A distributed Bragg reflectors (DBR) layer may be stacked on the passivation layer 151 to improve light extraction efficiency of the first sub-pixel 101.

The first device electrode 161 of the first sub-pixel 101 may be formed on the transparent electrode layer 141. The first device electrode 161 of the first sub-pixel 101 may be electrically connected to the second semiconductor layer 101b of the first sub-pixel 101 through the transparent electrode layer 141.

Most of the second device electrode 162 of the first sub-pixel 101 may be formed on the passivation layer 151, and a portion of the second device electrode 162 of the first sub-pixel 101 may be formed on the first semiconductor layer 101a of the first sub-pixel 101. The second device electrode 162 of the first sub-pixel 101 may be electrically insulated from the transparent electrode layer 141 through the passivation layer 151. The second device electrode 162 of the first sub-pixel 101 may be electrically connected to the first semiconductor layer 101a of the first sub-pixel 101.

The second sub-pixel 102 may have a structure similar to that of the first sub-pixel 101. For example, the second sub-pixel 102 may include a first semiconductor layer 102a in contact with the adhesive layer 122, a second semiconductor layer 102b, and an active layer 102c provided between the first semiconductor layer 102a and the second semiconductor layer 102b. In this case, the active layer 102c may emit light in a green wavelength band. The second sub-pixel 102 may further include a transparent electrode layer 142, a passivation layer 152, a first device electrode 163, and a second device electrode 164.

The third sub-pixel 103 may have a structure similar to that of the first sub-pixel 101. For example, the third sub-pixel 103 may include a first semiconductor layer 103a in contact with an adhesive layer 123, a second semiconductor layer 103b, and an active layer 103c provided between the first semiconductor layer 103a and the second semiconductor layer 103b. In this case, the active layer 103c may emit light in a red wavelength band. The third sub-pixel 103 may further include a passivation layer 153, a first device electrode 165, and a second device electrode 166.

Referring to FIG. 6, three first substrate electrodes 51, 53, and 55 and three second substrate electrodes 52, 54, and 56 may be provided on the substrate 30 for each light-emitting diode 100. For example, the substrate 30 may include the first substrate electrodes 51, 53, and 55, which are electrically connected to the first device electrodes 161, 163, and 165 of the first, second, and third sub-pixels 101, 102, and 103, respectively, and the second substrate electrodes 52, 54, and 56, which are electrically connected to the second device electrodes 162, 164, and 166 of the first, second, and third sub-pixels 101, 102, and 103, respectively. The second substrate electrodes 52, 54, and 56 may be connected to a ground layer provided on the substrate 30.

In this manner, six substrate electrodes 51, 52, 53, 54, 55, and 56 may be provided on the substrate 30 for each light-emitting diode 100. When respective predetermined voltages are applied to the three first substrate electrodes 51, 53, and 55, the light-emitting diode 100 may individually drive the first sub-pixel 101, the second sub-pixel 102, and the third sub-pixel 103. The light-emitting diode 100 may individually emit blue light from the first sub-pixel 101, green light from the second sub-pixel 102, and red light from the third sub-pixel 103.

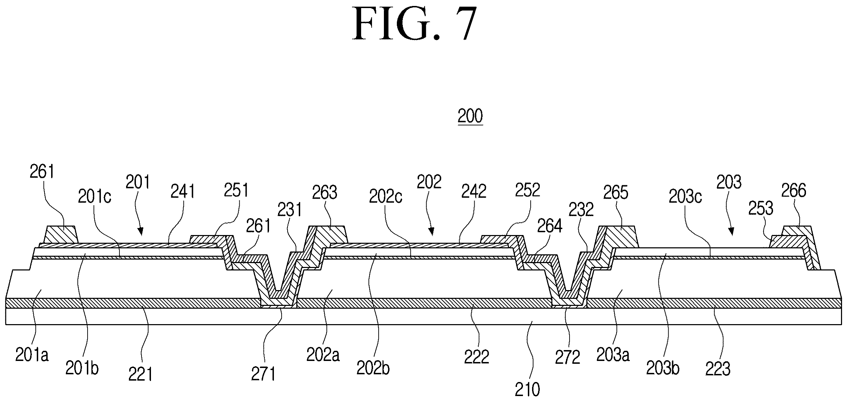

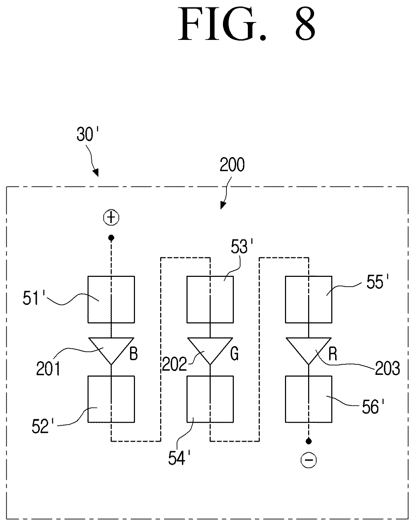

FIG. 7 is a cross-sectional view illustrating a light-emitting diode according to at least one embodiment. FIG. 8 is a circuit diagram schematically illustrating connections between a group of substrate electrodes and the light-emitting diode according to at least one embodiment illustrated in FIG. 7. Hereinafter, in describing a light-emitting diode 200 illustrated in FIG. 7, the same names are used for the same components as those of the light-emitting diode 100 illustrated in FIG. 5 and detailed descriptions thereof are omitted.

The light-emitting diode 200 according to at least one embodiment illustrated in FIG. 7 may be formed as a single body in which first, second, and third sub-pixels 201, 202, and 203 are arranged parallel to one another in the horizontal direction as in the structure of the light-emitting diode 100 illustrated in FIG. 5. The first, second, and third sub-pixels 201, 202, and 203 of the light-emitting diode 200 differ from the foregoing light-emitting diode 100 in that first electrodes 261, 263, and 265 and the second electrodes 262, 264, and 266 are connected in series.

Referring to FIG. 7, the light-emitting diode 200 according to at least one embodiment may include the first sub-pixel 201, the second sub-pixel 202, and the third sub-pixel 203 arranged on a single metal pad 210 to be parallel to one another at predetermined intervals. In this case, the first, second, and third sub-pixels 201, 202, and 203 may be attached to an upper surface of the metal pad 210 by using adhesive layers 221, 222, and 223 each formed of an insulating material. The first, second, and third sub-pixels 201, 202, and 203 may each be electrically insulated from the metal pad 210.

The metal pad 210 may be used as a member that physically connects the light-emitting diode 200 to a substrate pad provided on the substrate 30. The substrate pad may be formed of a metal capable of metallic bonding with the metal pad 210 of the light-emitting diode 200.

The light-emitting diode 200 may further include a first partition 231 disposed between the first sub-pixel 201 and the second sub-pixel 202 and a second partition 232 disposed between the second sub-pixel 202 and the third sub-pixel 203. Accordingly, the first partition 231 may block or reflect light emitted from the first sub-pixel 201 toward the second sub-pixel 202 and may block or reflect light emitted from the second sub-pixel 201 toward the first sub-pixel 201.

The first sub-pixel 201 may include a first semiconductor layer 201a in contact with the adhesive layer 221, a second semiconductor layer 201b, and an active layer 201c provided between the first semiconductor layer 201a and the second semiconductor layer 201b. The active layer 201c may emit light in the blue wavelength band.

The first sub-pixel 201 may further include a transparent electrode layer 241, a passivation layer 251, a first device electrode 261, and a second device electrode 262.

The transparent electrode layer 241 may be provided on the second semiconductor layer 201b of the first sub-pixel 201. The transparent electrode layer 241 may be electrically connected to the second semiconductor layer 201b of the first sub-pixel 201. The passivation layer 251 may partially cover the transparent electrode layer 241 and a left portion of the first sub-pixel 201. Specifically, as illustrated in FIG. 7, the passivation layer 251 may cover the second electrode 262 of the first sub-pixel 201 that partially covers a left portion of the first sub-pixel 201 and the first electrode 263 of the second sub-pixel 202 that partially covers a right portion of the second sub-pixel 202.

The first device electrode 261 may be formed on the transparent electrode layer 241. The device electrode 261 of the first sub-pixel 201 may be electrically connected to the second semiconductor layer 201b of the first sub-pixel 201 through the transparent electrode layer 241.

The second device electrode 262 of the first sub-pixel 201 may be formed on the first semiconductor layer 201a of the first sub-pixel 201 to be electrically connected to the first semiconductor layer 201a of the first sub-pixel 201. The second device electrode 262 of the first sub-pixel 201 may be electrically insulated from the transparent electrode layer 241 through the passivation layer 251. The second device electrode 262 of the first sub-pixel 201 may be integrally formed with the first device electrode 263 of the second sub-pixel 202. Accordingly, the first sub-pixel 201 and the second sub-pixel 202 may be electrically connected in series.

The second sub-pixel 202 may include a first semiconductor layer 202a in contact with the adhesive layer 222, a second semiconductor layer 202b, and an active layer 202c provided between the first semiconductor layer 202a and the second semiconductor layer 202b. In this case, the active layer 202c may emit light in the green wavelength band.

The second sub-pixel 202 may further include a transparent electrode layer 242, a passivation layer 252, a first device electrode 263, and a second device electrode 264.

The transparent electrode layer 242 may be provided on the second semiconductor layer 202b of the second sub-pixel 202. The transparent electrode layer 242 may be electrically connected to the second semiconductor layer 202b of the second sub-pixel 202. The passivation layer 252 may partially cover the transparent electrode layer 242 and a left portion of the second sub-pixel 202. Specifically, as illustrated in FIG. 7, the passivation layer 252 may cover the second electrode 264 of the second sub-pixel 202 that partially covers a right portion of the second sub-pixel 202 and the first electrode 265 of the third sub-pixel 203 that partially covers a left portion of the third sub-pixel 203.

The first device electrode 263 of the second sub-pixel 202 may be formed on the transparent electrode layer 242. The first device electrode 263 of the second sub-pixel 202 may be electrically connected to the second semiconductor layer 202b of the second sub-pixel 202 through the transparent electrode layer 242. The first device electrode 263 of the second sub-pixel 202 may enable the second semiconductor layer 202b of the second sub-pixel 202 and the metal pad 210 to be electrically insulated from each other through an insulating layer 271 partially covering a left portion of the second semiconductor layer 202b and an upper surface of the metal pad 210. Here, the insulating layer 271 may correspond to a passivation layer.

The second device electrode 264 of the second sub-pixel 202 may be formed on the first semiconductor layer 202a of the second sub-pixel 202 to be electrically connected to the first semiconductor layer 202a of the second sub-pixel 202. The second device electrode 264 of the second sub-pixel 202 may be electrically insulated from the transparent electrode layer 242 through the passivation layer 252. The second device electrode 264 of the second sub-pixel 202 may be integrally formed with the first device electrode 265 of the third sub-pixel 203. Accordingly, the second sub-pixel 202 and the third sub-pixel 203 may be electrically connected in series.

The third sub-pixel 203 may include a first semiconductor layer 203a in contact with the adhesive layer 223, a second semiconductor layer 203b, and an active layer 203c provided between the first semiconductor layer 203a and the second semiconductor layer 203b. The active layer 203c may emit light in the red wavelength band.

The third sub-pixel 203 may further include a passivation layer 253, a first device electrode 265, and a second device electrode 266.

The first device electrode 265 of the third sub-pixel 203 may be electrically connected to the second semiconductor layer 203b of the third sub-pixel 203. The first device electrode 265 of the third sub-pixel 203 may enable the first semiconductor layer 203a of the third sub-pixel 203 and the metal pad 210 to be electrically insulated from each other through an insulating layer 272 partially covering a left portion of the third sub-pixel 203 and the upper surface of the metal pad 210. Here, the insulating layer 272 may correspond to a passivation layer.

The second device electrode 266 of the third sub-pixel 203 may be electrically connected to the first semiconductor layer 203a of the third sub-pixel 203 and may be separated therefrom through the passivation layer 253 to be electrically insulated from the second semiconductor layer 203b of the third sub-pixel 203.

The light-emitting diode 200 may have a structure in which the first device electrode 261 of the first sub-pixel 201, the second device electrode 262 of the first sub-pixel 201, the first device electrode 263 of the second sub-pixel 202, the second device electrode 264 of the second sub-pixel 202, the first device electrode 265 of the third sub-pixel 203, and the second device electrode 266 of the third sub-pixel 203 are electrically connected in series.

Referring to FIG. 8, three first substrate electrodes 51', 53', and 55' and three second substrate electrodes 52', 54', and 56' may be provided on the substrate 30' for each light-emitting diode 200. For example, the substrate 30' may include the first substrate electrodes 51', 53', and 55', which are electrically connected to the first device electrodes 261, 263, and 265 of the first, second, and third sub-pixels 201, 202, and 203, respectively, and the second substrate electrodes 52', 54', and 56', which are electrically connected to the second device electrodes 262, 264, and 266 of the first, second, and third sub-pixels 201, 202, and 203, respectively. The second substrate electrodes 52', 54', and 56' may be connected to a ground layer provided on the substrate 30'.

Six substrate electrodes may be provided on the substrate 30' for each light-emitting diode 200. In this case, the first sub-pixel 201, the second sub-pixel 202, and the third sub-pixel 203 of the light-emitting diode 200 may be electrically connected in series.

Accordingly, when a predetermined voltage is applied to the first device electrode 261 of the first sub-pixel 201 of the light-emitting diode 200, the first sub-pixel 201, the second sub-pixel 202, and the third sub-pixel 203 may be simultaneously driven. In addition, when the predetermined voltage is applied to the first device electrode 263 of the second sub-pixel 202, the second sub-pixel 202 and the third sub-pixel 203 may be simultaneously driven. In addition, when the predetermined voltage is applied to the first device electrode 265 of the third sub-pixel 203, the third sub-pixel 203 may be driven.

In this manner, when the first sub-pixel 201, the second sub-pixel 202, and the third sub-pixel 203 of the light-emitting diode 200 are electrically connected in series, the first sub-pixel 201, the second sub-pixel 202, and the third sub-pixel 203 of the light-emitting diode 200 may be simultaneously driven or individually driven.

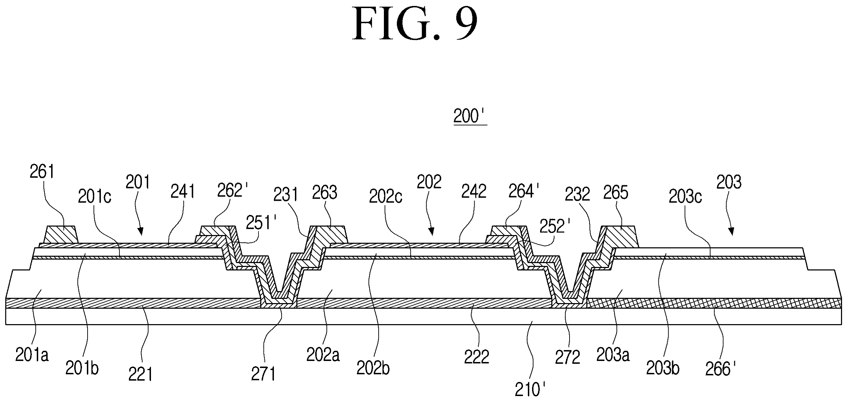

FIG. 9 is a cross-sectional view illustrating a light-emitting diode according to at least one embodiment. Hereinafter, in describing a light-emitting diode 200' illustrated in FIG. 9, the same names are used for the same components as those of the light-emitting diode 200 illustrated in FIG. 7 and detailed descriptions thereof are omitted.

Referring to FIG. 9, the light-emitting diode 200' may have a structure in which the first device electrode 261 of the first sub-pixel 201, a second device electrode 262' of the first sub-pixel 201, the first device electrode 263 of the second sub-pixel 202, a second device electrode 264' of the second sub-pixel 202, the first device electrode 265 of the third sub-pixel 203, and a second device electrode 266' of the third sub-pixel 203 are electrically connected in series.

The light-emitting diode 200' may include the second device electrode 266' of the third sub-pixel 203 provided between the first semiconductor layer 203a of the third sub-pixel 203 and a single metal pad 210'. In this case, the first semiconductor layer 203a of the third sub-pixel 203 may be electrically connected to the metal pad 210' through the second device electrode 266' of the third sub-pixel 203. Accordingly, unlike the metal pad 210 illustrated in FIG. 7, which functions merely as a member for physically fixing the light-emitting diode 200 to the substrate 30', the metal pad 210' may perform a function of the second device electrode 266' of the third sub-pixel 203. That is, the metal pad 210' may be used as a member for extending the second device electrode 266' of the third sub-pixel 203.

The second device electrode 262' and 264' of the first sub-pixel 201 and the second sub-pixel 202 of the light-emitting diode 200' may extend upward to upper sides of the corresponding passivation layers 251' and 252', respectively.

The light-emitting diode 200' may have the first sub-pixel 201, the second sub-pixel 202, and the third sub-pixel 203 electrically connected in series as in the light-emitting diode 200 illustrated in FIG. 7. Accordingly, the first sub-pixel 201, the second sub-pixel 202, and the third sub-pixel 203 of the light-emitting diode 200' may be simultaneously driven or individually driven.

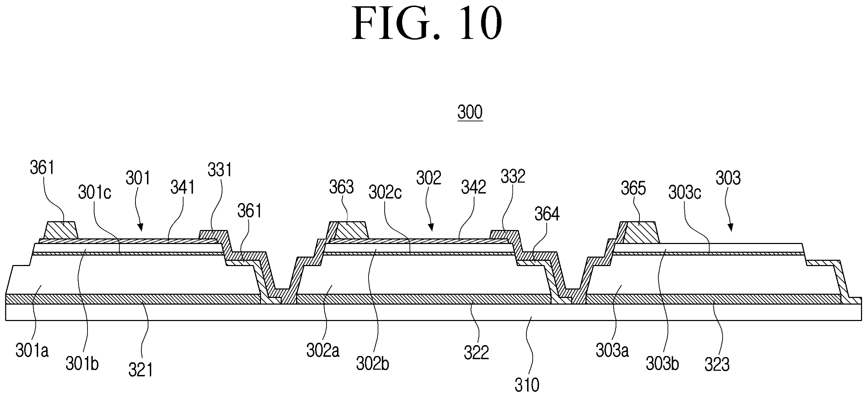

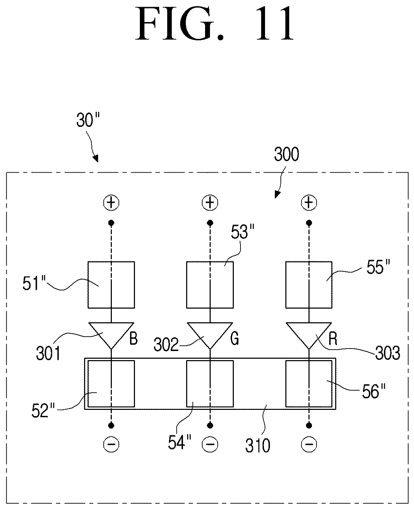

FIG. 10 is a cross-sectional view illustrating a light-emitting diode according to at least one embodiment. FIG. 11 is a circuit diagram schematically illustrating connections between substrate electrodes and the light-emitting diode according to at least one embodiment illustrated in FIG. 10. Hereinafter, in describing a light-emitting diode 300 illustrated in FIG. 10, the same names are used for the same components as those of the light-emitting diode 100 illustrated in FIG. 5 and detailed descriptions thereof are omitted.

Referring to FIG. 10, the light-emitting diode 300 according to at least one embodiment may further include a first partition 331 disposed between a first sub-pixel 301 and a second sub-pixel 302 and a second partition 332 disposed between the second sub-pixel 302 and a third sub-pixel 303. Accordingly, the first partition 331 may block or reflect light emitted from the first sub-pixel 301 toward the second sub-pixel 302 and may block or reflect light emitted from the second sub-pixel 302 toward the first sub-pixel 301.

The first sub-pixel 301 may include a first semiconductor layer 301a in contact with an adhesive layer 321, a second semiconductor layer 301b, and an active layer 301c provided between the first semiconductor layer 301a and the second semiconductor layer 301b. The active layer 301c may emit light in the blue wavelength band.

The first sub-pixel 301 may further include a transparent electrode layer 341, a first device electrode 361, and a second device electrode 362. The transparent electrode layer 341 may be provided on the second semiconductor layer 301b of the first sub-pixel 301. The transparent electrode layer 341 may be electrically connected to the second semiconductor layer 301b. The first device electrode 361 of the first sub-pixel 301 may be formed on the transparent electrode layer 341. The first device electrode 361 of the first sub-pixel 301 may be electrically connected to the second semiconductor layer 301b of the first sub-pixel 301 through the transparent electrode layer 341. The second device electrode 362 of the first sub-pixel 301 may have one side formed on the first semiconductor layer 301a of the first sub-pixel 301 and the other side formed on a portion of an upper surface of a single metal pad 310. Accordingly, the second device electrode 362 of the first sub-pixel 301 may electrically connect the first semiconductor layer 301a of the first sub-pixel 301 to the metal pad 310.

The second sub-pixel 302 may include a first semiconductor layer 302a in contact with an adhesive layer 322, a second semiconductor layer 302b, and an active layer 302c provided between the first semiconductor layer 302a and the second semiconductor layer 302b. The active layer 302c may emit light in the green wavelength band.

The second sub-pixel 302 may further include a transparent electrode layer 342, a first device electrode 363, and a second device electrode 364. The transparent electrode layer 342 may be provided on the second semiconductor layer 302b of the second sub-pixel 302. The transparent electrode layer 242 may be electrically connected to the second semiconductor layer 202b. The first device electrode 363 of the second sub-pixel 302 may be formed on the transparent electrode layer 342. The first device electrode 363 of the second sub-pixel 302 may be electrically connected to the second semiconductor layer 302b of the second sub-pixel 302 through the transparent electrode layer 342. The second device electrode 364 of the second sub-pixel 302 may have one side formed on the second semiconductor layer 302b of the second sub-pixel 302 and the other side formed on a portion of the upper surface of the metal pad 310. Accordingly, the second device electrode 364 of the second sub-pixel 302 may electrically connect the first semiconductor layer 302a of the second sub-pixel 302 to the metal pad 310.

The third sub-pixel 303 may include a first semiconductor layer 303a in contact with an adhesive layer 323, a second semiconductor layer 303b, and an active layer 303c provided between the first semiconductor layer 303a and the second semiconductor layer 303b. The active layer 303c may emit light in the red wavelength band.

The third sub-pixel 303 may further include a first device electrode 365 and a second device electrode 366. The first device electrode 365 of the third sub-pixel 303 may be formed on the second semiconductor layer 303b. The first device electrode 365 of the third sub-pixel 303 may be electrically connected to the second semiconductor layer 303b. The second device electrode 366 of the third sub-pixel 303 may have one side formed on the second semiconductor layer 303b of the third sub-pixel 303 and the other side formed on a portion of the upper surface of the metal pad 310. Accordingly, the second device electrode 366 of the third sub-pixel 303 may electrically connect the first semiconductor layer 303a of the third sub-pixel 303 to the metal pad 310.

In this manner, the light-emitting diode 300 may have the first sub-pixel 301, the second sub-pixel 302, and the third sub-pixel 303 electrically connected in parallel through the metal pad 310. Here, the parallel connection indicates that the respective second device electrodes 362, 364, and 366 of the first sub-pixel 301, the second sub-pixel 302, and the third sub-pixel 303 of the light-emitting diode 300 are electrically commonly connected to the metal pad 310.

Referring to FIG. 11, three first substrate electrodes 51", 53", and 55" and three second substrate electrodes 52", 54", and 56" may be provided on a substrate 30" for each light-emitting diode 300. For example, the substrate 30" may include the first substrate electrodes 51", 53", and 55", which are electrically connected to the first device electrodes 361, 363, and 365 of the first, second, and third sub-pixels 301, 302, and 303, respectively, and the second substrate electrodes 52", 54", and 56", which are electrically connected to the metal pad 310 through the second device electrodes 362, 364, and 366 of the first, second, and third sub-pixels 301, 302, and 303, respectively.

The second substrate electrodes 52", 54", and 56" may be connected to a ground layer provided on the substrate 30". In this case, the second substrate electrodes 52", 54", and 56" may be formed as a single substrate electrode and electrically connected to the metal pad 310.

When predetermined voltages are applied to the three first substrate electrodes 51", 53", and 55", respectively, the light-emitting diode 300 may individually drive the first sub-pixel 301, the second sub-pixel 302, and the third sub-pixel 303. The light-emitting diode 300 may individually emit blue light from the first sub-pixel 301, green light from the second sub-pixel 302, and red light from the third sub-pixel 303.

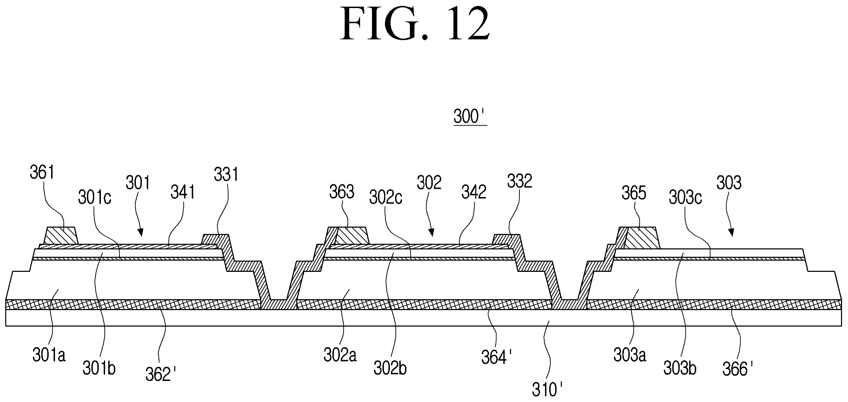

FIG. 12 is a cross-sectional view illustrating a light-emitting diode according to at least one embodiment. Hereinafter, in describing a light-emitting diode 300' illustrated in FIG. 12, the same names are used for the same components as those of the light-emitting diode 300 illustrated in FIG. 10 and detailed descriptions thereof are omitted.

Referring to FIG. 12, the light-emitting diode 300' according to at least one embodiment may have second device electrodes 362', 364', and 366' of the first, second, and third sub-pixels 301, 302, and 303 electrically connected to the metal pad 210', respectively.

For example, the second device electrode 362' of the first sub-pixel 301 may be provided between the first semiconductor layer 301a of the first sub-pixel 301 and the metal pad 210'. Accordingly, the first semiconductor layer 301a of the first sub-pixel 301 may be electrically connected to the metal pad 210' through the second device electrode 362' of the first sub-pixel 301.

The second device electrode 364' of the second sub-pixel 302 may be provided between the first semiconductor layer 302a of the second sub-pixel 302 and the metal pad 210'. Accordingly, the first semiconductor layer 302a of the second sub-pixel 302 may be electrically connected to the metal pad 210' through the second device electrode 364' of the second sub-pixel 302.

The second device electrode 366' of the third sub-pixel 303 may be provided between the first semiconductor layer 303a of the third sub-pixel 303 and the metal pad 210'. Accordingly, the first semiconductor layer 303a of the third sub-pixel 303 may be electrically connected to the metal pad 210' through the second device electrode 366' of the third sub-pixel 303.

Accordingly, a single metal pad 310' provided in the light-emitting diode 300' may perform functions of the respective second device electrodes 362', 364', and 366' of the first, second, and third sub-pixels 301, 302, and 303. That is, the metal pad 310' may be used as a member for extending the respective second device electrodes 362', 364', and 366' of the first, second, and third sub-pixels 301, 302, and 303.

The light-emitting diode 300' may individually drive the first sub-pixel 301, the second sub-pixel 302, and the third sub-pixel 303 when predetermined voltages are applied to the first device electrodes 361, 363, and 365 of the first, second, and third sub-pixels 301, 302, and 303, respectively.

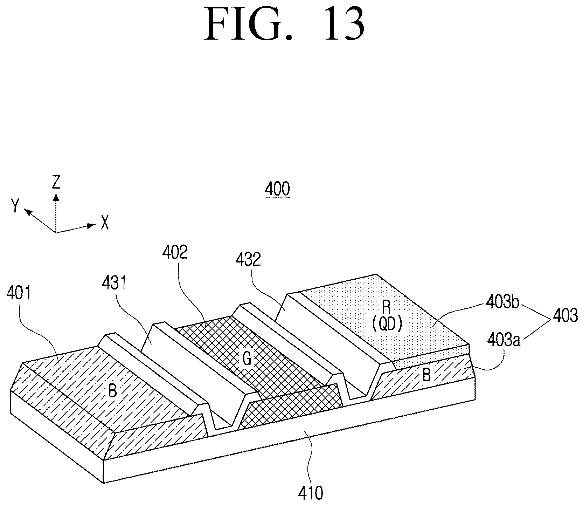

FIG. 13 is a cross-sectional view illustrating a light-emitting diode according to at least one embodiment. Hereinafter, in describing a light-emitting diode 400 illustrated in FIG. 13, the same names are used for the same components as those of the light-emitting diode 100 illustrated in FIG. 4 and detailed descriptions thereof are omitted.

Referring to FIG. 13, the light-emitting diode 400 according to at least one embodiment may include a single metal pad 410, a first sub-pixel 401, a second sub-pixel 402, and a third sub-pixel 403 arranged on the single metal pad 410 to be parallel to one another in one direction (e.g., the X-axis direction), and a first partition 431 disposed between the first and second sub-pixels 401 and 402 and a second partition 432 disposed between the second and third sub-pixels 402 and 403.

In this case, the first and second sub-pixels 401 and 402 may correspond to semiconductor materials having the same physical property. For example, the first, second, and third sub-pixels 401, 402, and 403 may be gallium nitride (GaN). In this case, the first sub-pixel 401 may emit blue light. The second sub-pixel 402 may emit green light.

The third sub-pixel 403 may include a semiconductor layer 403a formed of a semiconductor material having the same physical property as the first and second sub-pixels 401 and 402, and a color conversion layer 403b stacked on the semiconductor layer 403a.

The color conversion layer 403b of the third sub-pixel 403 may include red quantum dots (QD) excited by blue light emitted from the semiconductor layer 403a of the third sub-pixel 403 and capable of emitting light in the red wavelength band. The quantum dot refer to a small spherical semiconductor particle having a size in nanometers (nm, one billionth of a meter), and may include a core having a size of about 2 nm to 10 nm and a shell formed of zinc sulfide (ZnS). Here, the core of the quantum dot may include cadmium selenide (CdSe), cadmium telluride (CdTe), or cadmium sulfide (CdS). The quantum dot itself may emit light having a specific wavelength when an electric field is applied thereto or may emit light having a specific wavelength when absorbing high-energy light. Here, the wavelength of the emitted light may depend on the size of the quantum dot. The quantum dot may emit shorter wavelength light as its size decreases and longer wavelength light as its size increases. For example, a quantum dot having a diameter of about 6 nm may emit light that is approximately red.

In addition, the color conversion layer 403b of the third sub-pixel 403 may include red nano phosphors excited by light emitted from the semiconductor layer 403a of the third sub-pixel 403 and capable of emitting light in the red wavelength band. For example, the red nano phosphor may include Si₁₋ₓCaₓAlSiN₃:Eu²⁺ (SCASN). In this case, the red nano phosphor may have a particle size distribution average value (d₅₀) of less than 0.5 µm (preferably 0.1 µm < d₅₀ < 0.5 µm).

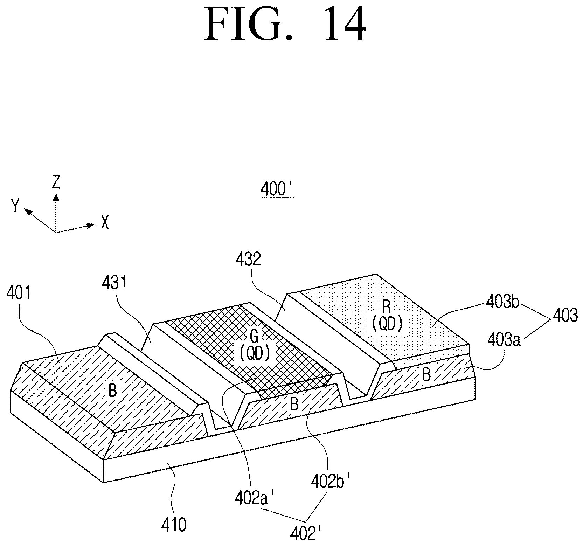

FIG. 14 is a cross-sectional view illustrating a light-emitting diode according to at least one embodiment. Hereinafter, in describing a light-emitting diode 400' illustrated in FIG. 14, the same names are used for the same components as those of the light-emitting diode 400 illustrated in FIG. 13 and detailed descriptions thereof are omitted.

Referring to FIG. 14, the light-emitting diode 400' according to at least one embodiment may have most of the configuration identical to the light-emitting diode 400 illustrated in FIG. 13, and the structure of a second sub-pixel 402' may be different therefrom.

The second sub-pixel 402' may include a semiconductor layer 402a' formed of a semiconductor material having the same physical property as the first and third sub-pixels 401 and 403 and a color conversion layer 402b' stacked on the semiconductor layer 402a'.

The color conversion layer 402b' of the second sub-pixel 402' may include green quantum dots or green nano phosphors excited by blue light emitted from the semiconductor layer 402a' of the second sub-pixel 402' and capable of emitting light in the green wavelength band.

The light-emitting diode 100, 200, 200', 300, 300', 400, or 400' according to at least one embodiment may utilize a conductive metal pad as a first device electrode (a cathode electrode or a P electrode) or a second device electrode (an anode electrode or an N electrode), thereby enabling the light-emitting diode to be electrically connected to the substrate without a separate circuit configuration and facilitating configuration of electrical circuits in series or in parallel depending on the application and usage thereof.

The light-emitting diode 100, 200, 200', 300, 300', 400, or 400' according to at least one embodiment does not use a red light-emitting diode having characteristics of severe light efficiency degradation due to temperature increase (e.g., a light drop of 1% to 2% per 1 °C), and uses red and blue light-emitting diodes for all red/green/blue (R/G/B) sub-pixels, thereby enabling full-color implementation without a separate temperature compensation process.

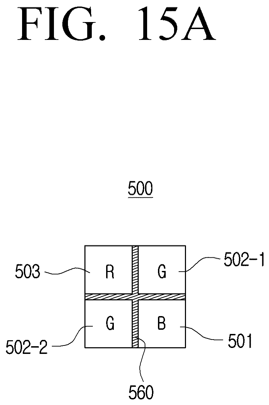

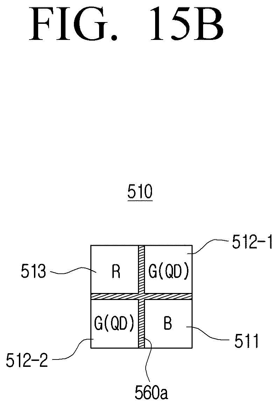

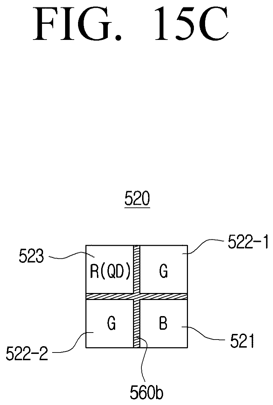

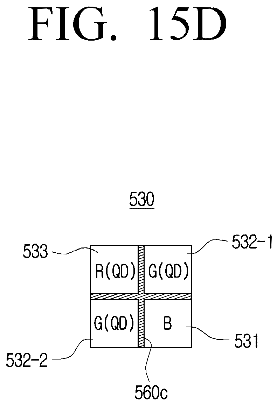

FIGS. 15A, 15B, 15C, and 15D are views illustrating examples in which a light-emitting diode according to at least one embodiment has a light-emitting region partitioned into four parts by partitions.

Referring to FIG. 15A, a light-emitting diode 500 may include a first sub-pixel 501, second sub-pixels 502-1 and 502-2, and a third sub-pixel 503. The first sub-pixel 501, the second sub-pixels 502-1 and 502-2, and the third sub-pixel 503 may be partitioned by partitions 560.

The first sub-pixel 501 may include a semiconductor layer that emits light in the blue wavelength band. The second sub-pixels 502-1 and 502-2 may include semiconductor layers that emit light in the green wavelength band. The third sub-pixel 503 may include a semiconductor layer that emits light in the red wavelength band.

The first sub-pixel 501 and the third sub-pixel 503 may be arranged diagonally from each other. The two second sub-pixels 502-1 and 502-2 may also be arranged diagonally from each other. In this manner, the light-emitting diode 500 may be formed as a single body including the plurality of sub-pixels 501, 502-1, 502-2, and 503.

Referring to FIG. 15B, a light-emitting diode 510 may include a first sub-pixel 511, second sub-pixels 512-1 and 512-2, and a third sub-pixel 513. The first sub-pixel 511, the second sub-pixels 512-1 and 512-2, and the third sub-pixel 513 may be partitioned by partitions 560a.

The first sub-pixel 511 may include a semiconductor layer that emits light in the blue wavelength band. The third sub-pixel 513 may include a semiconductor layer that emits light in the red wavelength band.

The two second sub-pixels 512-1 and 512-2 may each include a semiconductor layer that emits light in the blue wavelength band and a color conversion layer stacked on the semiconductor layer. The color conversion layer of the second sub-pixel 512-1 or 512-2 may include green quantum dots or green nano phosphors excited by blue light emitted from the semiconductor layer of the second sub-pixel 512-1 or 512-2 and capable of emitting light in the green wavelength band.

Referring to FIG. 15C, a light-emitting diode 520 may include a first sub-pixel 521, second sub-pixels 522-1 and 522-2, and a third sub-pixel 523. The first sub-pixel 521, the second sub-pixels 522-1 and 522-2, and the third sub-pixel 523 may be partitioned by partitions 560b.

The first sub-pixel 521 may include a semiconductor layer that emits light in the blue wavelength band. The two second sub-pixels 522-1 and 522-2 may include semiconductor layers that emit light in the green wavelength band.

The third sub-pixel 523 may include a semiconductor layer that emits light in the blue wavelength band and a color conversion layer stacked on the semiconductor layer. The color conversion layer of the third sub-pixel 523 may include red quantum dots or red nano phosphors excited by blue light emitted from the semiconductor layer of the third sub-pixel 523 and capable of emitting light in the red wavelength band.

Referring to FIG. 15D, a light-emitting diode 560c may include a first sub-pixel 531, second sub-pixels 532-1 and 532-2, and a third sub-pixel 533. The first sub-pixel 531, the second sub-pixels 532-1 and 532-2, and the third sub-pixel 533 may be partitioned by partitions 560c.

The first sub-pixel 531 may include a semiconductor layer that emits light in the blue wavelength band.

The two second sub-pixels 532-1 and 532-2 may each include a semiconductor layer that emits light in the blue wavelength band and a color conversion layer stacked on the semiconductor layer. The color conversion layer of the second sub-pixel 532-1 or 532-2 may include green quantum dots or green nano phosphors excited by blue light emitted from the semiconductor layer of the second sub-pixel 532-1 or 532-2 and capable of emitting light in the green wavelength band.

The third sub-pixel 533 may include a semiconductor layer that emits light in the blue wavelength band and a color conversion layer stacked on the semiconductor layer. The color conversion layer of the third sub-pixel 533 may include red quantum dots or red nano phosphors excited by blue light emitted from the semiconductor layer of the third sub-pixel 533 and capable of emitting light in the red wavelength band.

The light-emitting diode according to at least one embodiment is not limited to the case where the first, second, and third sub-pixels are partitioned into four regions, and may also be partitioned into three regions. This configuration is described with reference to the drawings.

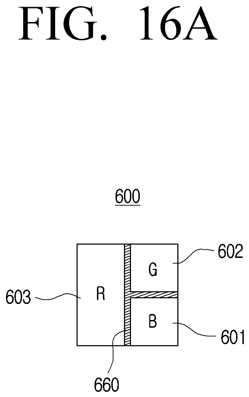

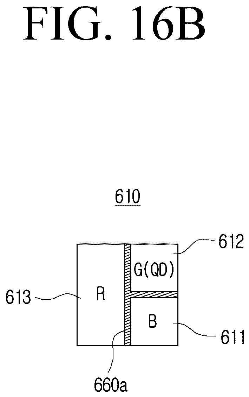

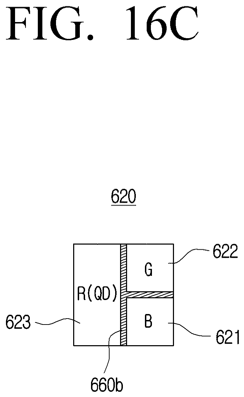

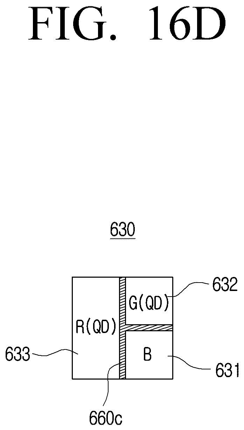

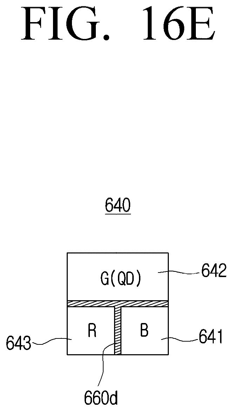

FIGS. 16A, 16B, 16C, 16D, and 16E are views illustrating examples in which a light-emitting diode according to at least one embodiment has a light-emitting region partitioned into three parts by partitions.

Referring to FIG. 16A, a light-emitting diode 600 may include a first sub-pixel 601, a second sub-pixel 602, and a third sub-pixel 603. The first sub-pixel 601, the second sub-pixel 602, and the third sub-pixel 603 may be partitioned by partitions 660.

The first sub-pixel 601 and the second sub-pixel 602 may be arranged in the same column direction. The third sub-pixel 603 may be disposed in a column adjacent to the first sub-pixel 601 and the second sub-pixel 602. In this case, an area of the third sub-pixel 603 may be equal to or similar to the sum of areas of the first sub-pixel 601 and the second sub-pixel 602. In this manner, the light-emitting diode 600 may be formed as a single body including the plurality of sub-pixels 601, 602, and 603.

The first sub-pixel 601 may include a semiconductor layer that emits light in the blue wavelength band. The second sub-pixel 602 may include a semiconductor layer that emits light in the green wavelength band. The third sub-pixel 603 may include a semiconductor layer that emits light in the red wavelength band.

Referring to FIG. 16B, a light-emitting diode 610 may include a first sub-pixel 611, a second sub-pixel 612, and a third sub-pixel 613. The first sub-pixel 611, the second sub-pixel 612, and the third sub-pixel 613 may be partitioned by partitions 660a. In this case, an area of the third sub-pixel 613 may be equal to or similar to the sum of areas of the first sub-pixel 611 and the second sub-pixel 612.

The first sub-pixel 611 may include a semiconductor layer that emits light in the blue wavelength band. The third sub-pixel 613 may include a semiconductor layer that emits light in the red wavelength band.

The second sub-pixel 612 may include a semiconductor layer that emits light in the blue wavelength band and a color conversion layer stacked on the semiconductor layer. The color conversion layer of the second sub-pixel 612 may include green quantum dots or green nano phosphors excited by blue light emitted from the semiconductor layer of the second sub-pixel 612 and capable of emitting light in the green wavelength band.

Referring to FIG. 16C, a light-emitting diode 620 may include a first sub-pixel 621, a second sub-pixel 622, and a third sub-pixel 623. The first sub-pixel 621, the second sub-pixel 622, and the third sub-pixel 623 may be partitioned by partitions 660b. In this case, an area of the third sub-pixel 613 may be equal to or similar to the sum of areas of the first sub-pixel 611 and the second sub-pixel 612.

The first sub-pixel 611 may include a semiconductor layer that emits light in the blue wavelength band. The second sub-pixel 612 may include a semiconductor layer that emits light in the green wavelength band.

The third sub-pixel 613 may include a semiconductor layer that emits light in the blue wavelength band and a color conversion layer stacked on the semiconductor layer. The color conversion layer of the third sub-pixel 622 may include red quantum dots or red nano phosphors excited by blue light emitted from the semiconductor layer of the second sub-pixel 622 and capable of emitting light in the red wavelength band.

Referring to FIG. 16D, a light-emitting diode 630 may include a first sub-pixel 631, a second sub-pixel 632, and a third sub-pixel 633. The first sub-pixel 631, the second sub-pixel 632, and the third sub-pixel 633 may be partitioned by partitions 660c. In this case, an area of the third sub-pixel 633 may be equal to or similar to the sum of areas of the first sub-pixel 631 and the second sub-pixel 632.

The first sub-pixel 631 may include a semiconductor layer that emits light in the blue wavelength band.

The second sub-pixel 632 may include a semiconductor layer that emits light in the blue wavelength band and a color conversion layer stacked on the semiconductor layer. The color conversion layer of the second sub-pixel 632 may include green quantum dots or green nano phosphors excited by blue light emitted from the semiconductor layer of the second sub-pixel 632 and capable of emitting light in the green wavelength band.

The third sub-pixel 633 may include a semiconductor layer that emits light in the blue wavelength band and a color conversion layer stacked on the semiconductor layer. The color conversion layer of the third sub-pixel 632 may include red quantum dots or red nano phosphors excited by blue light emitted from the semiconductor layer of the second sub-pixel 632 and capable of emitting light in the red wavelength band.

Referring to FIG. 16E, a light-emitting diode 640 may include a first sub-pixel 641, a second sub-pixel 642, and a third sub-pixel 643. The first sub-pixel 641, the second sub-pixel 642, and the third sub-pixel 643 may be partitioned by partitions 660d.

The first sub-pixel 641 and the third sub-pixel 643 may be arranged in the same row direction. The second sub-pixel 642 may be disposed in a row adjacent to the first sub-pixel 641 and the third sub-pixel 643. In this case, an area of the second sub-pixel 642 may be equal to or similar to the sum of areas of the first sub-pixel 641 and the third sub-pixel 643. In this manner, the light-emitting diode 640 may be formed as a single body including the plurality of sub-pixels 641, 642, and 643.

The first sub-pixel 641 may include a semiconductor layer that emits light in the blue wavelength band. The third sub-pixel 642 may include a semiconductor layer that emits light in the red wavelength band.

The second sub-pixel 642 may include a semiconductor layer that emits light in the blue wavelength band and a color conversion layer stacked on the semiconductor layer. The color conversion layer of the second sub-pixel 642 may include green quantum dots or green nano phosphors excited by blue light emitted from the semiconductor layer of the second sub-pixel 642 and capable of emitting light in the green wavelength band.

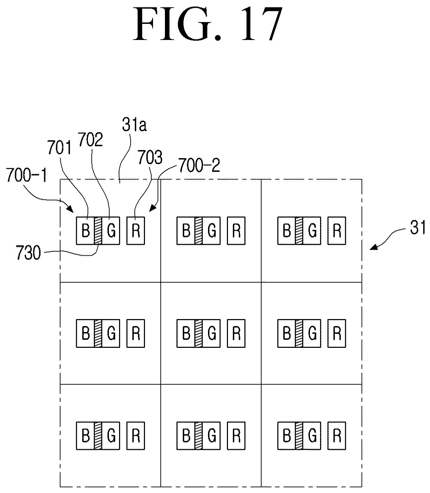

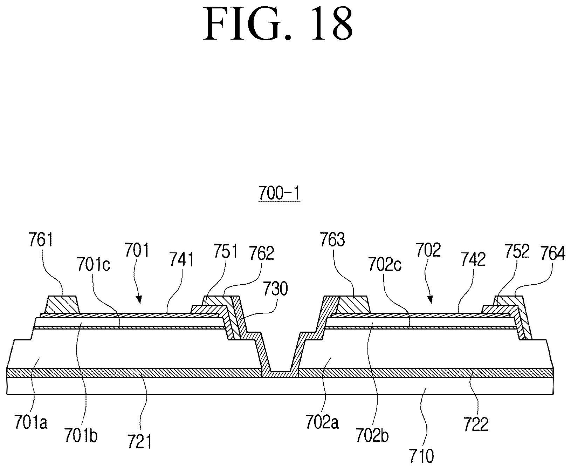

FIG. 17 is a plan view illustrating an example in which light-emitting diodes according to at least one embodiment are arranged on a substrate. FIG. 18 is a cross-sectional view illustrating the light-emitting diode according to at least one embodiment illustrated in FIG. 17.

The light-emitting diode according to at least one embodiment is described as having at least three sub-pixels arranged on a single metal pad, and is not limited thereto. For example, it is also possible that two sub-pixels are arranged on a single metal pad, and this configuration is described below with reference to the drawings.

FIG. 17 is a plan view illustrating an example in which the light-emitting diodes according to at least one embodiment are arranged on the substrate. FIG. 18 is a cross-sectional view illustrating the light-emitting diode according to at least one embodiment illustrated in FIG. 17.

Referring to FIG. 17, a plurality of pixel regions 31a each having a substantially lattice pattern may be provided on a front surface of a substrate 31. Two light-emitting diodes may be arranged in each pixel region 31a. For example, within one pixel region 31a, a first light-emitting diode 700-1 including a first sub-pixel 701 that emits blue light and a second sub-pixel 702 that emits green light, and a second light-emitting diode 700-2 including a third sub-pixel 703 that emits red light may be arranged.

Referring to FIG. 18, the first light-emitting diode 700-1 may include the first sub-pixel 701 and the second sub-pixel 702 arranged on a single metal pad 710 to be parallel to each other at a predetermined interval. In this case, the first and second sub-pixels 701 and 702 may be attached to an upper surface of the metal pad 710 by adhesive layers 721 and 722, respectively. The adhesive layers 721 and 722 may each be formed of an insulating material. Accordingly, the first and second sub-pixels 701 and 702 may each be electrically insulated from the metal pad 710.

The metal pad 710 may be used as a member for physically connecting the first light-emitting diode 700-1 to a substrate pad provided on the substrate 31. The substrate pad may be formed of a metal capable of metallic bonding with the metal pad 710 of the first light-emitting diode 700-1. The metal pad 710 may not only be used as a member for physically connecting the first light-emitting diode 700-1 to the substrate 31, but may also be used as, for example, a cathode terminal of the first light-emitting diode 700-1 that is electrically and physically connected to a cathode electrode (negative electrode) provided on the substrate 31.

The first light-emitting diode 700-1 may further include a partition 730 disposed between the first sub-pixel 701 and the second sub-pixel 702.

A lower side of the partition 730 may be in contact with a portion of the upper surface of the metal pad 710, a left portion of the partition 730 may cover a right portion of the first sub-pixel 701, and a right portion of the partition 730 may cover a left portion of the second sub-pixel 702. Accordingly, the partition 730 may block or reflect light emitted from the first sub-pixel 701 toward the second sub-pixel 702 and may block or reflect light emitted from the second sub-pixel 701 toward the first sub-pixel 701. The partition 730 may be deposited on the metal pad 710, the first sub-pixel 701, and the second sub-pixel 702 by a deposition process.

The first sub-pixel 701 may include a first semiconductor layer 701a in contact with the adhesive layer 721, a second semiconductor layer 701b, and an active layer 701c provided between the first semiconductor layer 701a and the second semiconductor layer 701b. The active layer 701c may emit light in the blue wavelength band.

The first sub-pixel 701 may further include a transparent electrode layer 741 (e.g., an indium tin oxide (ITO)), a passivation layer 751, a first device electrode 761, and a second device electrode 762.

The transparent electrode layer 741 may be provided on the second semiconductor layer 701b of the first sub-pixel 701. The transparent electrode layer 741 may be electrically connected to the second semiconductor layer 701b of the first sub-pixel 701. The passivation layer 751 may partially cover the transparent electrode layer 741 and a left portion of the first sub-pixel 701. The passivation layer 751 may physically separate and electrically insulate the transparent electrode layer 741 and the second device electrode 762 of the first sub-pixel 701 from each other. A distributed Bragg reflectors (DBR) layer may be stacked on the passivation layer 751 to improve the light extraction efficiency of the first sub-pixel 701.

The first device electrode 761 of the first sub-pixel 701 may be formed on the transparent electrode layer 741. The first device electrode 761 of the first sub-pixel 701 may be electrically connected to the second semiconductor layer 701b of the first sub-pixel 701 through the transparent electrode layer 741.

Most of the second device electrode 762 of the first sub-pixel 701 may be formed on the passivation layer 751, and a portion of the second device electrode 762 of the first sub-pixel 701 may be formed on the first semiconductor layer 701a of the first sub-pixel 701. The second device electrode 762 of the first sub-pixel 701 may be electrically insulated from the transparent electrode layer 741 through the passivation layer 751. The second device electrode 762 of the first sub-pixel 701 may be electrically connected to the first semiconductor layer 701a of the first sub-pixel 701.

The second sub-pixel 702 may have a structure similar to that of the first sub-pixel 701. For example, the second sub-pixel 702 may include a first semiconductor layer 702a in contact with the adhesive layer 722, a second semiconductor layer 702b, and an active layer 702c provided between the first semiconductor layer 702a and the second semiconductor layer 702b. In this case, the active layer 702c may emit light in the green wavelength band. The second sub-pixel 702 may further include a transparent electrode layer 742 and a passivation layer 752, a first device electrode 763, and a second device electrode 764.

The second sub-pixel 702 may also include a semiconductor layer that emits light in the blue wavelength band and a color conversion layer formed on the semiconductor layer. The color conversion layer of the second sub-pixel 702 may include green quantum dots or green nano phosphors excited by blue light emitted from the semiconductor layer of the second sub-pixel 702 and capable of emitting light in the green wavelength band.

The second light-emitting diode 700-2 may include the third sub-pixel 703. The third sub-pixel 703 may have a structure similar to that of the first sub-pixel 701. For example, the third sub-pixel 703 may include a first semiconductor layer, a second semiconductor layer, and an active layer provided between the first semiconductor layer and the second semiconductor layer. In this case, the active layer may emit light in the red wavelength band.

The third sub-pixel 703 may further include a first device electrode and a second device electrode. The first device electrode may be formed on the second semiconductor layer of the third sub-pixel 703. The second device electrode may be formed on the first semiconductor layer of the third sub-pixel 703.

The light-emitting diode according to at least one embodiment may have a structure in which a plurality of sub-pixels are arranged horizontally, and is not limited thereto. For example, the light-emitting diode according to at least one embodiment may include at least three sub-pixels formed as a single body, and the plurality of sub-pixels may be vertically stacked. Hereinafter, a light-emitting diode having a vertical stack structure according to at least one embodiment is described with reference to the drawings.

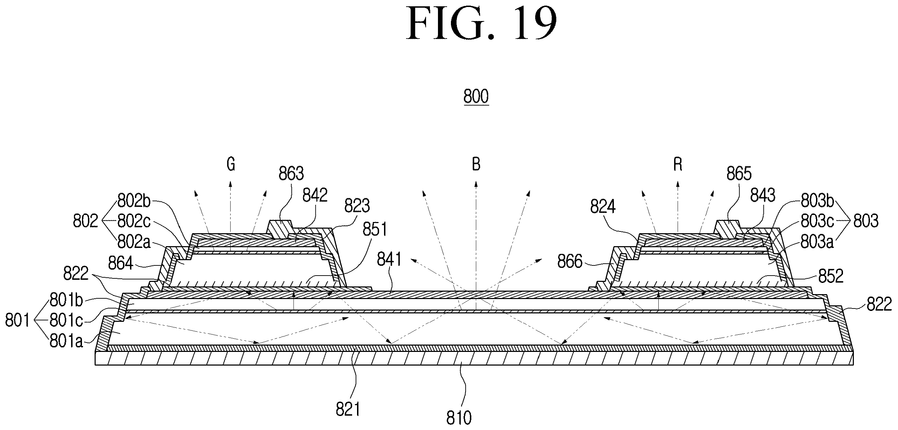

FIG. 19 is a cross-sectional view illustrating a light-emitting diode according to at least one embodiment.

Referring to FIG. 19, a light-emitting diode 800 according to at least one embodiment may include a single metal pad 810, a first sub-pixel 801 stacked on the metal pad 810, and a second sub-pixel 802 and a third sub-pixel 803 stacked on the first sub-pixel 801 while having a gap therebetween. A size of the first sub-pixel 801 may be greater than the sum of sizes of the second sub-pixel 802 and the third sub-pixel 803.

The first sub-pixel 801 may emit light in the blue wavelength band. The second sub-pixel 802 may emit light in the green wavelength band. The third sub-pixel 803 may emit light in the red wavelength band. In this manner, the light-emitting diode 800 may be formed as a single body including the plurality of sub-pixels 801, 802, and 803 that emit different colors of light.

The first sub-pixel 801 may include a first semiconductor layer 801a, a second semiconductor layer 801b, and an active layer 801c provided between the first semiconductor layer 801a and the second semiconductor layer 801b. In this case, the active layer 801c may emit light in the blue wavelength band.

The first sub-pixel 801 may include a first adhesive layer 821 formed of a metal material deposited on a bottom surface of the first semiconductor layer 801a of the first sub-pixel 801. The first sub-pixel 801 may be bonded to the metal pad 810 as the first adhesive layer 821 is metallurgically bonded to the metal pad 810. The first adhesive layer 821 may be a conductive metal material capable of reflecting blue light emitted from the active layer 801c of the first sub-pixel 801. The first adhesive layer 821 may function as a second device electrode (cathode electrode) of the first sub-pixel 801.

The first sub-pixel 801 may further include a first transparent electrode layer 841 (e.g., an indium tin oxide (ITO)) stacked on the second semiconductor layer 801b of the first sub-pixel 801. The first transparent electrode layer 841 may function as a first device electrode (anode electrode) of the first sub-pixel 801.

Side surfaces of the first sub-pixel 801 and an upper surface of the first transparent electrode layer 841 may be covered by a distributed Bragg reflectors (DBR) layer 822. The DBR layer 822 may include an organic material and serve as a passivation layer and as a reflective layer.

Blue light emitted from the first sub-pixel 801 may be reflected by the first adhesive layer 821 and the DBR layer 822. The blue light reflected by the first adhesive layer 821 and the DBR layer 822 may be emitted through a light-emitting surface of the first sub-pixel 801. The light-emitting surface of the first sub-pixel 801 may correspond to a portion of an upper surface of the second semiconductor layer 801b of the first sub-pixel 801 that is not covered by the second sub-pixel 802 and the third sub-pixel 803.

The second sub-pixel 802 may include a first semiconductor layer 802a, a second semiconductor layer 802b, and an active layer 802c provided between the first semiconductor layer 802a and the second semiconductor layer 802b. In this case, the active layer 802c may emit light in the green wavelength band. The second sub-pixel 802 may be bonded to an upper surface of the DBR layer 822 through a second adhesive layer 851 formed on a bottom surface of the first semiconductor layer 802a of the second sub-pixel 802.

The second sub-pixel 802 may further include a second transparent electrode layer 842 stacked on the second semiconductor layer 802b of the second sub-pixel 802, a first device electrode 863, and a second device electrode 864 electrically connected to the first transparent electrode layer 841 of the first sub-pixel 801.

Side surfaces of the second sub-pixel 802 and an upper surface of the second transparent electrode layer 842 may be covered by a first passivation layer 823. The first passivation layer 823 may physically separate and electrically insulate the second transparent electrode layer 842 and the first device electrode 863 of the second sub-pixel 802 from each other. A DBR layer may be stacked on the first passivation layer 823 to improve the light extraction efficiency of the second sub-pixel 802.

The third sub-pixel 803 may have a configuration similar to that of the second sub-pixel 802. The third sub-pixel 803 may include a first semiconductor layer 803a, a second semiconductor layer 803b, and an active layer 803c provided between the first semiconductor layer 803a and the second semiconductor layer 803b. In this case, the active layer 803c may emit light in the red wavelength band. The third sub-pixel 803 may be bonded to the upper surface of the DBR layer 822 through a third adhesive layer 852 formed on a bottom surface of the first semiconductor layer 803a of the third sub-pixel 803.

The third sub-pixel 803 may further include a third transparent electrode layer 843 stacked on the second semiconductor layer 803b of the third sub-pixel 803, a first device electrode 865, and a second device electrode 866 electrically connected to the first transparent electrode layer 841 of the first sub-pixel 801.

Side surfaces of the third sub-pixel 803 and an upper surface of the third transparent electrode layer 843 may be covered by a second passivation layer 824. The second passivation layer 824 may physically separate and electrically insulate the third transparent electrode layer 843 and the first device electrode 865 of the third sub-pixel 803 from each other. A DBR layer may be stacked on the second passivation layer 824 to improve the light extraction efficiency of the third sub-pixel 803.

In the light-emitting diode 800, when a predetermined voltage is applied to the first device electrode 863 of the second sub-pixel 802, the second sub-pixel 802 may be driven. The first sub-pixel 801 may be driven by a voltage applied to the first transparent electrode layer 841 of the first sub-pixel 801 through the second device electrode 864 of the second sub-pixel 802. Accordingly, when the predetermined voltage is applied to the first device electrode 863 of the second sub-pixel 802, the first sub-pixel 801 and the second sub-pixel 802 may be driven simultaneously.

In the light-emitting diode 800, when a predetermined voltage is applied to the first device electrode 865 of the third sub-pixel 803, the third sub-pixel 803 may be driven. The first sub-pixel 801 may be driven by a voltage applied to the first transparent electrode layer 841 of the first sub-pixel 801 through the second device electrode 866 of the third sub-pixel 803. Accordingly, when the predetermined voltage is applied to the first device electrode 865 of the third sub-pixel 803, the first sub-pixel 801 and the third sub-pixel 803 may be driven simultaneously.

In the light-emitting diode 800, when predetermined voltages are applied to the first device electrode 863 of the second sub-pixel 802 and the first device electrode 865 of the third sub-pixel 802, the first, second, and third sub-pixels 801, 802, and 803 may be driven simultaneously.

Hereinafter, a manufacturing process of the light-emitting diode 800 according to at least one embodiment is described with reference to the drawings.

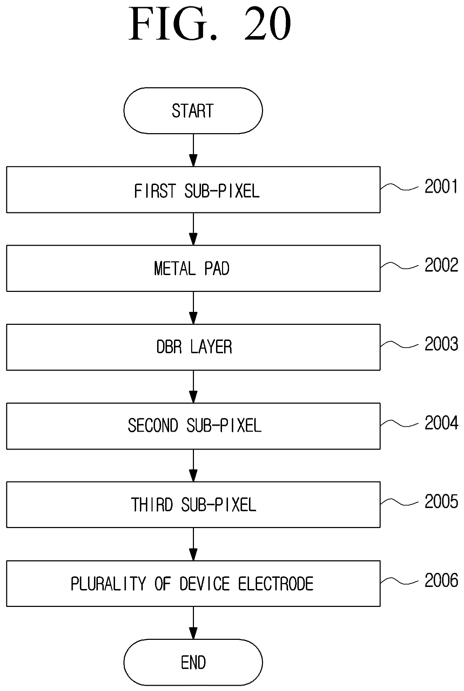

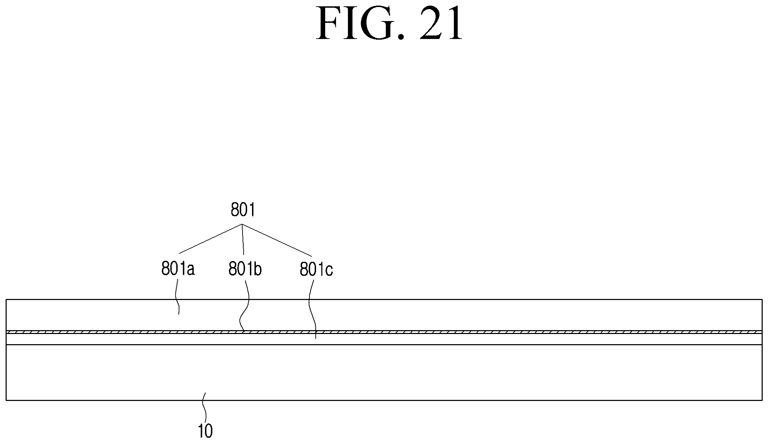

FIG. 20 is a flowchart schematically illustrating a manufacturing process of the light-emitting diode according to at least one embodiment illustrated in FIG. 19. FIGS. 21 to 29 are views illustrating the manufacturing process of the light-emitting diode illustrated in FIG. 19.

Referring to FIG. 21, the first sub-pixel 801 may be formed on a wafer 10 (e.g., a sapphire substrate) through an epitaxy process (step 2001 in FIG. 20). The first sub-pixel 801 formed on the wafer 10 may be partitioned into a plurality of first sub-pixels 801 through a mesa etching process and an isolation process.

The first sub-pixel 801 may include the first semiconductor layer 801a, the second semiconductor layer 801b, and the active layer 801c formed between the first semiconductor layer 801a and the second semiconductor layer 801b through ion implantation. The first semiconductor layer 801a may be a p-type semiconductor layer doped with a p-type dopant. The second semiconductor layer 801b may be an n-type semiconductor layer doped with an n-type dopant. The active layer 801c may include a single quantum well (SQW) structure or a multiple quantum well (MQW) structure, and may emit light in the blue wavelength band.

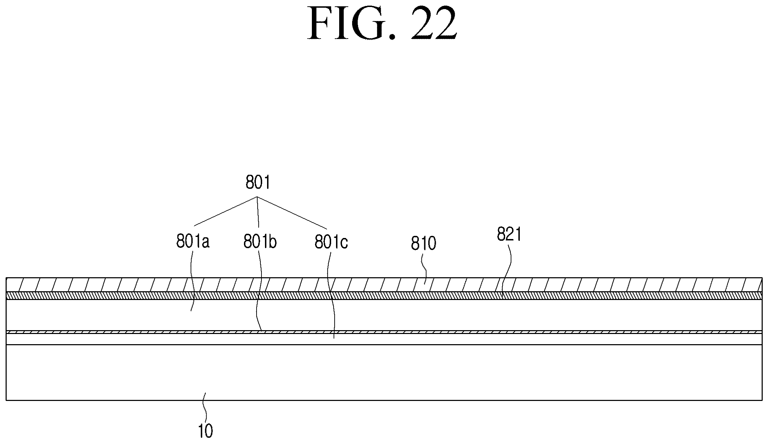

Referring to FIG. 22, the first adhesive layer 821 may be deposited on the second semiconductor layer 801b of the first sub-pixel 801. The metal pad 810 may be bonded to the second semiconductor layer 801b of the first sub-pixel 801 through the first adhesive layer 821 (step 2002 in FIG. 20). The metal pad 810 may be bonded to the first adhesive layer 821 formed of a conductive metal material by metal bonding through thermal compression. In this case, the metal pad 810 may be electrically connected to the second semiconductor layer 801b of the first sub-pixel 801 through the conductive first adhesive layer 821.

The first adhesive layer 821 may be a metal material capable of reflecting blue light emitted from the active layer 801c of the first sub-pixel 801. In addition, the metal pad 810 may also be formed of a metal material capable of reflecting blue light emitted from the active layer 801c of the first sub-pixel 801.

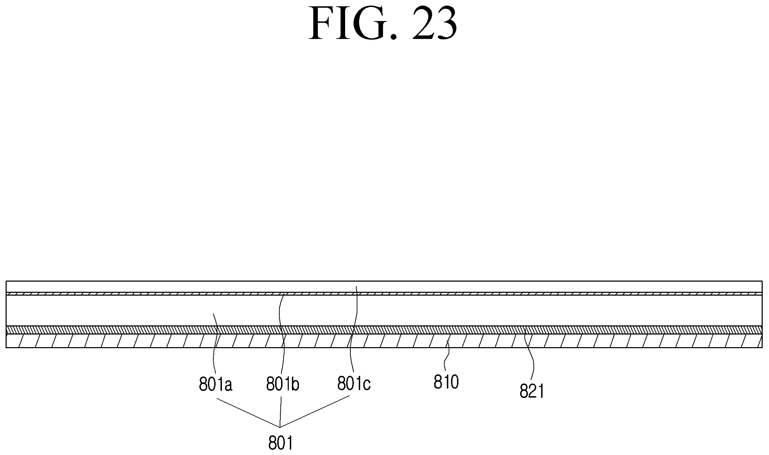

Referring to FIG. 23, the first sub-pixel 801 may be separated from the wafer 10. For example, the wafer 10 may be separated from the first sub-pixel 801 through a laser lift-off process. The first sub-pixel 801 may be supported by the metal pad 810 in a subsequent process.

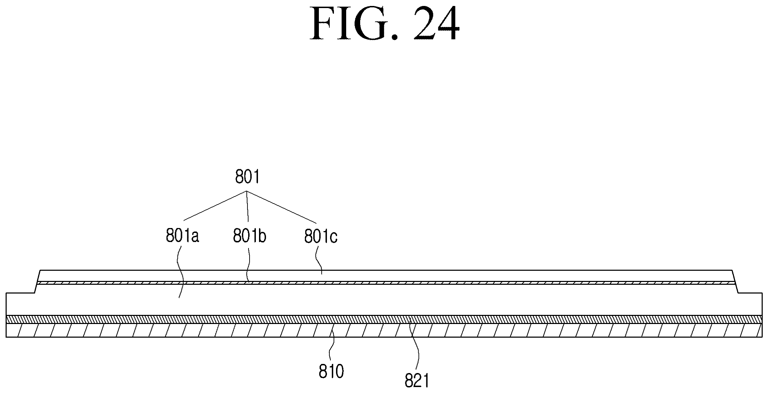

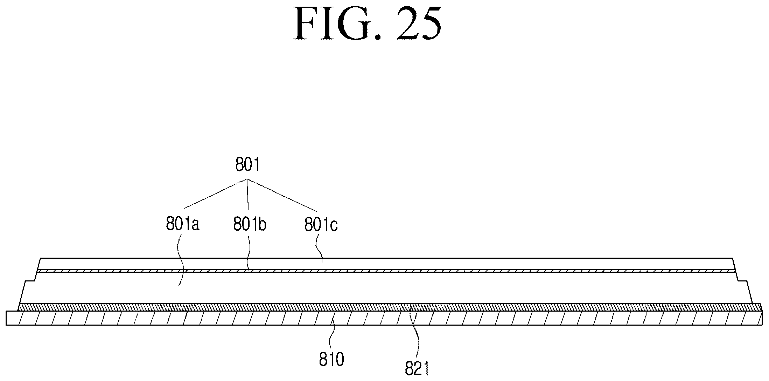

Referring to FIG. 24, the first sub-pixel 801 bonded to the metal pad 810 may be mesa-etched. Referring to FIG. 25, the mesa-etched first sub-pixel 801 may be isolated and partitioned into a plurality of first sub-pixels 801 each having a predetermined size.

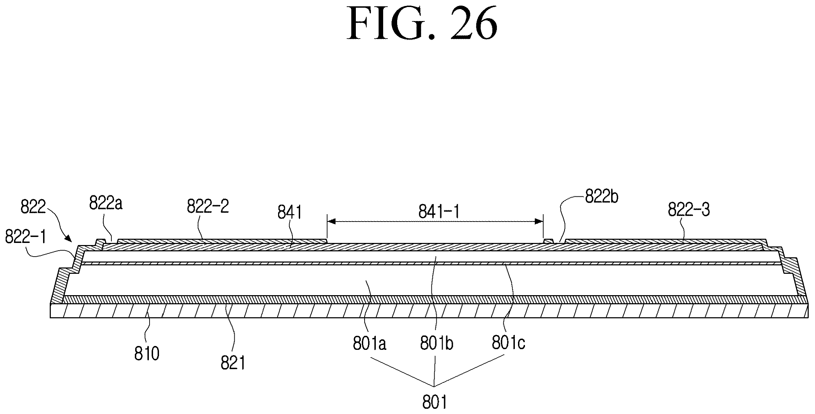

Referring to FIG. 26, the first transparent electrode layer 841 may be deposited on the second semiconductor layer 801b of the first sub-pixel 801. The first transparent electrode layer 841 may function as the first device electrode (anode electrode) of the first sub-pixel 801. The first adhesive layer 821 in contact with the first semiconductor layer 801a of the first sub-pixel 801 may function as the second device electrode (cathode electrode) of the first sub-pixel 801.

The distributed Bragg reflectors (DBR) layer 822 may be deposited on the side surfaces of the first sub-pixel 801 and the first transparent electrode layer 841 (step 2003 in FIG. 20). The DBR layer 822 may include a first portion 822-1 covering the side surfaces of the first sub-pixel 801, and a second portion 822-2 and a third portion 822-3 covering the first transparent electrode layer 841. The DBR layer 822 may include an organic material and may serve as a passivation layer and a reflective layer.

The second portion 822-2 and the third portion 822-3 of the DBR layer 822 may be arranged at a predetermined interval D from each other. Therefore, a portion 841-1 of the first transparent electrode layer 841 corresponding to a space between the second portion 822-2 and the third portion 822-3 of the DBR layer 822 may not be covered by the DBR layer 822. Accordingly, blue light emitted from the active layer 801c of the first sub-pixel 801 may be reflected by the first adhesive layer 821 and the DBR layer 822, and emitted through the portion 841-1 of the first transparent electrode layer 841 (see FIG. 19).

A first contact hole 822a may be formed in the second portion 822-2 of the DBR layer 822 through an etching process to allow the second device electrode 864 of the second sub-pixel 802 to be electrically connected to the first transparent electrode layer 841. A second contact hole 822b may be formed in the third portion 822-3 of the DBR layer 822 through an etching process to allow the second device electrode 866 of the third sub-pixel 803 to be electrically connected to the first transparent electrode layer 841.

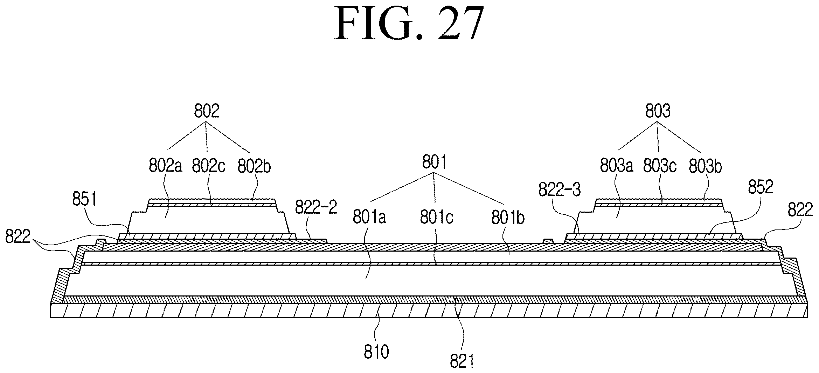

Referring to FIG. 27, the second adhesive layer 851 may be applied on the second portion 822-2 of the DBR layer 822. The second sub-pixel 802 may be disposed on the second adhesive layer 851 (step 2004 in FIG. 20). The second sub-pixel 802 may be grown on a separate wafer (e.g., a sapphire substrate), may undergo mesa etching and isolation processes, and then be transferred onto the second portion 822-2 of the DBR layer 822.

The third adhesive layer 852 may be applied on the third portion 822-3 of the DBR layer 822. The third sub-pixel 803 may be disposed on the third adhesive layer 852 (step 2005 in FIG. 20). The third sub-pixel 803 may be grown on a separate wafer (e.g., a gallium arsenide (GaAs) substrate), may undergo mesa etching and isolation processes, and then be transferred onto the third portion 822-3 of the DBR layer 822. The third adhesive layer 852 may be applied on the third portion 822-3 of the DBR layer 822 together with the second adhesive layer 851 when the second adhesive layer 851 is applied on the second portion 822-2 of the DBR layer 822.

In this manner, the second sub-pixel 802 and the third sub-pixel 803 may be stacked on the first sub-pixel 801.

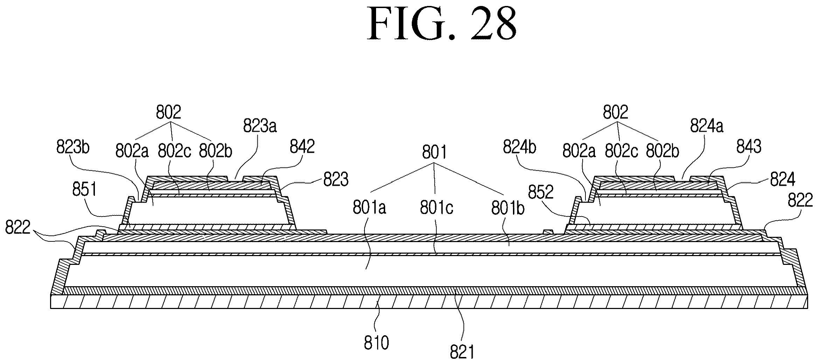

Referring to FIG. 28, the second transparent electrode layer 842 may be deposited on the second semiconductor layer 802b of the second sub-pixel 802. The second sub-pixel 802 may include the first semiconductor layer 802a, the second semiconductor layer 802b, and the active layer 802c formed between the first semiconductor layer 802a and the second semiconductor layer 802b through ion implantation. The active layer 802c may emit light in the green wavelength band.

The third transparent electrode layer 843 may be deposited on the second semiconductor layer 803b of the third sub-pixel 803. The third sub-pixel 803 may include the first semiconductor layer 803a, the second semiconductor layer 803b, and the active layer 803c formed between the first semiconductor layer 803a and the second semiconductor layer 803b through ion implantation. The active layer 803c may emit light in the red wavelength band.

The second and third transparent electrode layers 842 and 843 may be simultaneously deposited on the second semiconductor layer 802b of the second sub-pixel 802 and the second semiconductor layer 803b of the third sub-pixel 803, respectively.

The first passivation layer 823 may be deposited on the side surfaces of the second sub-pixel 802 and the second transparent electrode layer 842. The second passivation layer 824 may be deposited on the side surfaces of the third sub-pixel 803 and the third transparent electrode layer 843. The first and second passivation layers 823 and 824 may be simultaneously deposited on the side surfaces of the second sub-pixel 802 and the second transparent electrode layer 842, and on the side surfaces of the third sub-pixel 803 and the third transparent electrode layer 843, respectively.

A third contact hole 823a may be formed in the first passivation layer 823 to allow the first device electrode 863 of the second sub-pixel 802 to be electrically connected to the second transparent electrode layer 842. In addition, a fourth contact hole 823b may be formed in the first passivation layer 823 to allow the second device electrode 864 of the second sub-pixel 802 to be electrically connected to the first semiconductor layer 802a of the second sub-pixel 802.

A fifth contact hole 824a may be formed in the second passivation layer 824 to allow the first device electrode 865 of the third sub-pixel 803 to be electrically connected to the third transparent electrode layer 843. In addition, a sixth contact hole 824b may be formed in the second passivation layer 824 to allow the second device electrode 866 of the third sub-pixel 803 to be electrically connected to the first semiconductor layer 803a of the third sub-pixel 803.

The first passivation layer 823 may be formed of a transparent organic material to transmit green light emitted from the active layer 802c of the second sub-pixel 802. Similarly, the second passivation layer 824 may be formed of a transparent organic material to transmit red light emitted from the active layer 803c of the third sub-pixel 803.

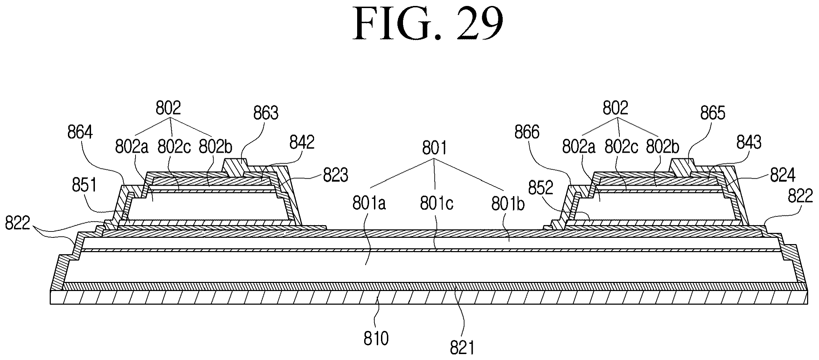

FIG. 29 is a cross-sectional view illustrating the light-emitting diode according to at least one embodiment.

Referring to FIG. 29, the first device electrode 863 and the second device electrode 864 of the second sub-pixel 802 and the first device electrode 865 and the second device electrode 866 of the third sub-pixel 803 may be formed (step 2006 in FIG. 20).

The second device electrode 864 of the second sub-pixel 802 may electrically connect the first semiconductor layer 802a of the second sub-pixel 802 and the first transparent electrode layer 841 to each other. The first transparent electrode layer 841 may function as the first device electrode of the first sub-pixel 801. Accordingly, when a voltage is applied to the second device electrode 864 of the second sub-pixel 802, the first sub-pixel 801 may be driven simultaneously with the second sub-pixel 802.

The second device electrode 866 of the third sub-pixel 803 may electrically connect the first semiconductor layer 803a of the third sub-pixel 803 and the first transparent electrode layer 841 to each other. The first transparent electrode layer 841 may function as the first device electrode of the first sub-pixel 801. Accordingly, when a voltage is applied to the second device electrode 866 of the third sub-pixel 803, the first sub-pixel 801 may be driven simultaneously with the third sub-pixel 803.

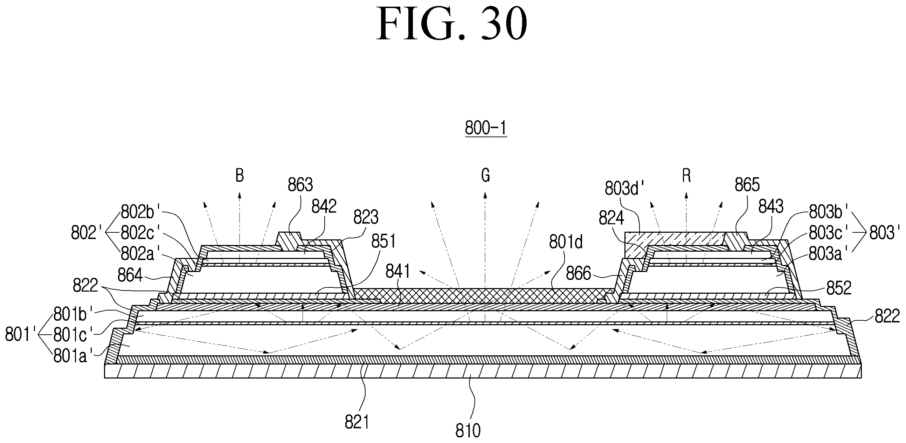

FIG. 30 is a cross-sectional view illustrating a light-emitting diode according to at least one embodiment. In describing a light-emitting diode 800-1 illustrated in FIG. 30, the same names are used for the same components as those of the light-emitting diode 800 illustrated in FIG. 19, and detailed descriptions thereof are omitted.

Referring to FIG. 30, a first sub-pixel 801' may emit blue light from the active layer 801c'. The first sub-pixel 801' may further include a first color conversion layer 801d'. The first color conversion layer 801d' may be deposited on the first transparent electrode layer 841'. The first color conversion layer 801d' may include green quantum dots or green nano phosphors excited by blue light emitted from the active layer 801c' of the first sub-pixel 801' and capable of emitting light in the green wavelength band.

A second sub-pixel 802' may include a first semiconductor layer 802a', a second semiconductor layer 802b', and an active layer 802c' that emits light in the green wavelength band, formed between the first semiconductor layer 802a' and the second semiconductor layer 802b' through ion implantation.

A third sub-pixel 803' may include a first semiconductor layer 803a', a second semiconductor layer 803b', and an active layer 803c' capable of emitting light in the blue wavelength band formed between the first semiconductor layer 803a' and the second semiconductor layer 803b' through ion implantation. The third sub-pixel 803' may further include a second color conversion layer 803d'. The second color conversion layer 803d' may be deposited on the second passivation layer 824. The second color conversion layer 803d' may include red quantum dots or red nano phosphors excited by blue light emitted from the active layer 803c' of the third sub-pixel 803' and capable of emitting light in the red wavelength band.

The light-emitting diode 800-1 may emit green light from the first sub-pixel 801', emit green light from the second sub-pixel 802', and emit red light from the third sub-pixel 803'.

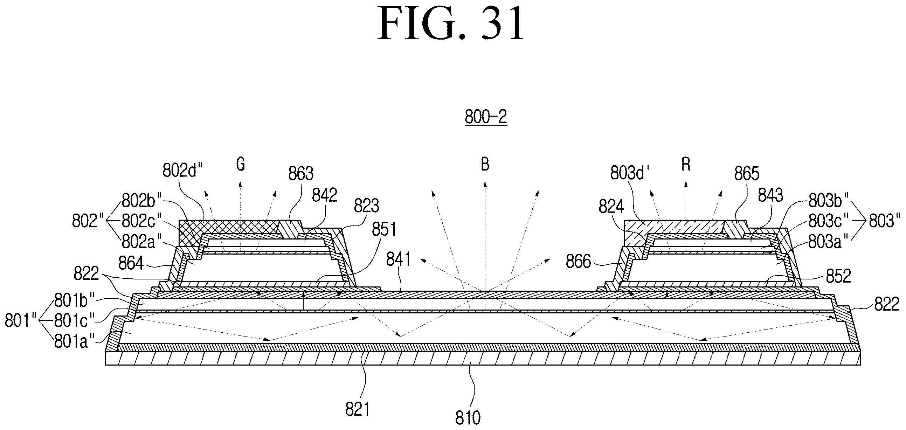

FIG. 31 is a cross-sectional view illustrating a light-emitting diode according to at least one embodiment. In describing a light-emitting diode 800-2 illustrated in FIG. 31, the same names are used for the same components as those of the light-emitting diode 800 illustrated in FIG. 19, and detailed descriptions thereof are omitted.

Referring to FIG. 31, a first sub-pixel 801" of the light-emitting diode 800-2 may have the same configuration as the first sub-pixel 801 of the light-emitting diode 800 illustrated in FIG. 19 and may emit blue light.

A second sub-pixel 802" may include a first semiconductor layer 802a", a second semiconductor layer 802b", and an active layer 802c" capable of emitting light in the blue wavelength band formed between the first semiconductor layer 802a" and the second semiconductor layer 802b" through ion implantation. The second sub-pixel 802" may further include a third color conversion layer 803d". The third color conversion layer 803d" may be deposited on the first passivation layer 823. The third color conversion layer 803d" may include green quantum dots or green nano phosphors excited by blue light emitted from the active layer 802c" of the second sub-pixel 802" and capable of emitting light in the green wavelength band.

A third sub-pixel 803" may include a first semiconductor layer 803a", a second semiconductor layer 803b", and an active layer 803c" capable of emitting light in the blue wavelength band formed between the first semiconductor layer 803a" and the second semiconductor layer 803b" through ion implantation. The third sub-pixel 803" may further include a second color conversion layer 803d". The second color conversion layer 803d" may be deposited on the second passivation layer 824. The second color conversion layer 803d" may include red quantum dots or red nano phosphors excited by blue light emitted from the active layer 803c" of the third sub-pixel 803" and capable of emitting light in the red wavelength band.

Accordingly, the light-emitting diode 800-2 may emit blue light from the first sub-pixel 801", emit green light from the second sub-pixel 802", and emit red light from the third sub-pixel 803".

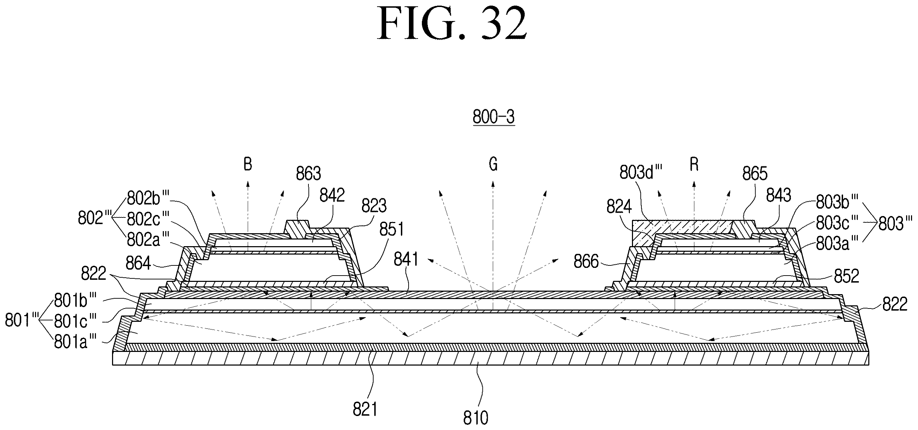

FIG. 32 is a cross-sectional view illustrating a light-emitting diode according to at least one embodiment. In describing a light-emitting diode 800-3 illustrated in FIG. 32, the same names are used for the same components as those of the light-emitting diode 800 illustrated in FIG. 19, and detailed descriptions thereof are omitted.

Referring to FIG. 31, a first sub-pixel 801‴ may include a first semiconductor layer 801a"', a second semiconductor layer 801b‴, and an active layer 803c‴ capable of emitting light in the green wavelength band formed between the first semiconductor layer 803a‴ and the second semiconductor layer 803b‴ through ion implantation.

A second sub-pixel 802‴ may include a first semiconductor layer 802a"', a second semiconductor layer 802b"', and an active layer 803c‴ capable of emitting light in the blue wavelength band formed between the first semiconductor layer 802a‴ and the second semiconductor layer 802b‴ through ion implantation.

A third sub-pixel 803‴ may include a first semiconductor layer 803a‴, a second semiconductor layer 803b‴, and an active layer 803c‴ capable of emitting light in the blue wavelength band formed between the first semiconductor layer 803a‴ and the second semiconductor layer 803b‴ through ion implantation. The third sub-pixel 803‴ may further include a fifth color conversion layer 803d‴. The fifth color conversion layer 803d‴ may be deposited on the second passivation layer 824. The fifth color conversion layer 803d‴ may include red quantum dots or red nano phosphors excited by blue light emitted from the active layer 801c‴ of the third sub-pixel 803‴ and capable of emitting light in the red wavelength band.

Accordingly, the light-emitting diode 800-3 may emit green light from the first sub-pixel 801‴, emit blue light from the second sub-pixel 802‴, and emit red light from the third sub-pixel 803"'.

The light-emitting diodes 800, 800-1, 800-2, and 800-3 according to at least one embodiment may commonly have a structure in which the second sub-pixel 802, 802', 802", and 802‴ and the third sub-pixel 803, 803', 803", and 803‴ are stacked on the first sub-pixel 801, 801', 801", and 801‴. In this case, light emitted from the active layer 801c, 801c', 801c", and 801c‴ of the first sub-pixel 801, 801', 801", and 801‴ may not be projected onto the second sub-pixel 802, 802', 802", and 802‴ and the third sub-pixel 803, 803', 803", and 803‴ due to the DBR layer 822.

The light-emitting diodes 800, 800-1, 800-2, and 800-3 according to at least one embodiment may implement the R/G/B full color from a single light-emitting diode. Accordingly, it is not necessary to separately provide a red light-emitting diode, a blue light-emitting diode, and a green light-emitting diode for each pixel. In addition, the light-emitting diode 800, 800-1, 800-2, or 800-3 according to at least one embodiment does not use a red light-emitting diode having characteristics of severe light efficiency degradation due to temperature increase (e.g., a light drop of 1% to 2% per 1°C), and uses blue and red light-emitting diodes for all R/G/B sub-pixels, thereby enabling full-color implementation without a separate temperature compensation process.

The light-emitting diode 800, 800-1, 800-2, or 800-3 according to at least one embodiment may utilize a conductive metal pad as the first device electrode (cathode electrode or P electrode) or the second device electrode (anode electrode or N electrode), thereby enabling the light-emitting diode to be electrically connected to the substrate without a separate circuit configuration and facilitating the configuration of electrical circuits in series or in parallel depending on the application and usage thereof.

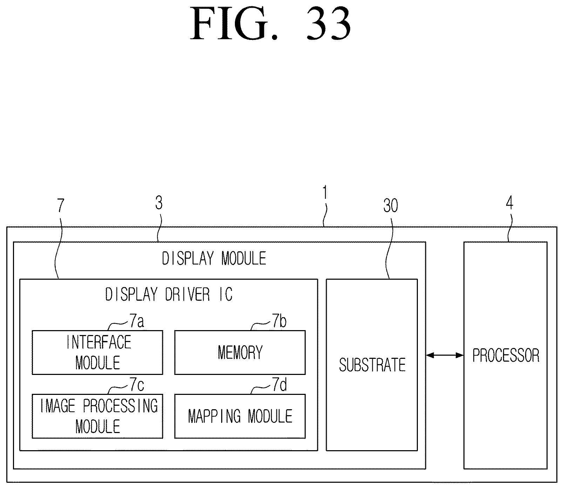

FIG. 33 is a block diagram illustrating a display apparatus according to at least one embodiment.

Referring to FIG. 33, a display apparatus 1 may include the display module 3 and a processor 4. The display module 3 may include the substrate 30 and a display driver integrated circuit (IC) 7 for controlling the substrate 30.

The processor 4 may be implemented as a digital signal processor (DSP), a microprocessor, a graphics processing unit (GPU), an artificial intelligence (AI) processor, a neural processing unit (NPU), or a time controller (TCON) for processing digital image signals. However, the processor 4 is not limited thereto, and may include at least one of a central processing unit (CPU), a micro controller unit (MCU), a micro processing unit (MPU), a controller, an application processor (AP), a communication processor (CP), or an advanced RISC machine (ARM) processor, or may be defined by these terms. In addition, the processor 4 may be implemented as a system-on-chip (SoC) or a large scale integration (LSI) in which a processing algorithm is embedded, or may be implemented as an application specific integrated circuit (ASIC) or a field programmable gate array (FPGA).

The processor 4 may operate an operating system or an application to control hardware or software components connected to the processor 4, and may perform various data processing and operations. In addition, the processor 4 may load instructions or data received from at least one of other components into a volatile memory for processing, and may store various data in a non-volatile memory.

The display driver IC 7 may include an interface module 7a, a memory 7b (e.g., a buffer memory), an image processing module 7c, or a mapping module 7d. The display driver IC 7 may receive image information including image data or video control signals corresponding to commands for controlling the image data from another component of the display apparatus 1 through the interface module 7a. For example, According to an embodiment, the image information may be received from the processor 4 for example, a main processor such as an application processor or an auxiliary processor such as a graphics processing unit operating independently from the functions of the main processor.

The display driver IC 7 may communicate with a sensor module through the interface module 7a. In addition, the display driver IC 7 may store at least a portion of the received image information in the memory 7b, for example, on a frame basis. The image processing module 7c may perform preprocessing or postprocessing (e.g., resolution, brightness, or size adjustment) on at least a portion of the image data based at least on characteristics of the image data or characteristics of the substrate 30. The mapping module 7d may generate voltage values or current values corresponding to the image data that are preprocessed or postprocessed through the image processing module 7c. According to an embodiment, the generation of the voltage values or current values may be performed based at least in part on properties of pixels of the substrate 30 (e.g., arrangement of pixels (RGB stripe or pentile structure) or sizes of respective sub-pixels). At least some pixels of the substrate 30 may be driven based at least in part on the voltage values or current values to allow visual information (e.g., text, an image, or an icon) corresponding to the image data to be displayed through the substrate 30.

The display driver IC 7 may transmit a driving signal (e.g., a driver driving signal or a gate driving signal) to a display based on the image information received from the processor 4.

The display driver IC 7 may display an image based on the image signal received from the processor 4. For example, the display driver IC 7 may generate driving signals for/of a plurality of sub-pixels based on the image signal received from the processor 4 and may display the image by controlling emission of the plurality of sub-pixels based on the driving signals.

According to at least one embodiment, the display module 3 may further include a touch circuit. The touch circuit may include a touch sensor and a touch sensor integrated circuit (IC) for controlling the touch sensor. The touch sensor IC may control the touch sensor to detect a touch input or a hovering input at a designated position of the substrate 30. For example, the touch sensor IC may detect the touch input or the hovering input by measuring a change in a signal (e.g., voltage, light quantity, resistance, or charge amount) at a designated position of the substrate 30. The touch sensor IC may provide information regarding the detected touch input or hovering input (e.g., position, area, pressure, or time) to the processor 4. According to an embodiment, at least a portion of the touch circuit (e.g., the touch sensor IC) may be included as a part of the display driver IC 7, as a part of the substrate 30, or as a part of another component (e.g., an auxiliary processor) disposed outside the display module 3.

According to at least one embodiment, a pixel driving method of the display module 3 may be implemented as an active matrix (AM) driving method or a passive matrix (PM) driving method.

According to at least one embodiment, the display apparatus 1 may include the display module 3. The display module 3 may display various images. Here, the image may include a still image and/or a moving image. The display module 3 may display various images such as broadcast content or multimedia content. In addition, the display module 3 may display a user interface or icons.

According to at least one embodiment, the display module 3 may be applied by being installed in a wearable device, a portable device, a handheld device, or various electronic products or vehicle-mounted devices requiring a display.

According to at least one embodiment, the display apparatus 1 may include a plurality of display modules 3. The plurality of display modules 3 may be physically connected to implement a large display (e.g., a large format display). The large display may be implemented as a personal computer monitor, a high-resolution television, signage (or digital signage, or an electronic display) by connecting the plurality of display modules in a grid arrangement.

While the present disclosure has been shown and described above with reference to the various examples, it will be understood by those skilled in the art that various modifications in form and detail may be made without departing from the spirit and scope of the present disclosure as defined by the appended claims and their equivalents.

Although the embodiments are shown and described in the present disclosure as above, the present disclosure is not limited to the above-described specific embodiments, and may be variously modified by those skilled in the art to which the present disclosure pertains without departing from the gist of the present disclosure as claimed in the accompanying claims. These modifications should also be understood to fall within the scope and spirit of the present disclosure.

## Claims

1. A light-emitting diode comprising:
a metal pad;
a first sub-pixel, arrangeable on the metal pad, configured to emit light of a first color;
a second sub-pixel configured to emit light of a second color different from the light of the first color; and
a third sub-pixel configured to emit light of a third color different from the light of the first color from the first sub-pixel and the light of the second color from the second sub-pixel.

2. The light-emitting diode as claimed in claim 1, wherein the first sub-pixel, the second sub-pixel, and the third sub-pixel are arranged parallel to one another along a horizontal direction, and
the light-emitting diode further includes:
a first partition to be disposed between the first sub-pixel and the second sub-pixel, and
a second partition to be disposed between the second sub-pixel and the third sub-pixel.

3. The light-emitting diode as claimed in claim 2, wherein the first partition and the second partition respectively include a distributed Bragg reflector (DBR) structure.

4. The light-emitting diode as claimed in claim 2, wherein the first sub-pixel, the second sub-pixel, and the third sub-pixel are electrically insulated, respectively, from the metal pad through an insulating layer.

5. The light-emitting diode as claimed in claim 2, wherein the first sub-pixel, the second sub-pixel, and the third sub-pixel are electrically connected in series.

6. The light-emitting diode as claimed in claim 5, wherein the first sub-pixel, the second sub-pixel, and the third sub-pixel respectively include an anode device electrode and a cathode device electrode,
the cathode device electrode of the first sub-pixel is electrically connected to the anode device electrode of the second sub-pixel, and
the cathode device electrode of the second sub-pixel is electrically connected to the anode device electrode of the third sub-pixel.

7. The light-emitting diode as claimed in claim 6, wherein the cathode device electrode of the first sub-pixel and the anode device electrode of the second sub-pixel are integrally formed, and
the cathode device electrode of the second sub-pixel and the anode device electrode of the third sub-pixel are integrally formed.

8. The light-emitting diode as claimed in claim 7, wherein the cathode device electrode of the third sub-pixel is electrically connected to the metal pad.

9. The light-emitting diode as claimed in claim 5, wherein the first sub-pixel, the second sub-pixel, and the third sub-pixel respectively include an anode device electrode and a cathode device electrode, and
the cathode device electrode of the first sub-pixel, the cathode device electrode of the second sub-pixel, and the cathode device electrode of the third sub-pixel are electrically connected to the metal pad, respectively.

10. The light-emitting diode as claimed in claim 9, wherein the cathode device electrode of the first sub-pixel and the anode device electrode of the second sub-pixel are integrally formed, and
the cathode device electrode of the second sub-pixel and the anode device electrode of the third sub-pixel are integrally formed.

11. The light-emitting diode as claimed in claim 2, wherein one of the first sub-pixel, the second sub-pixel, and the third sub-pixel further includes a color conversion layer, and
the color conversion layer includes quantum dots or nano phosphors.

12. The light-emitting diode as claimed in claim 2, wherein the first sub-pixel includes a semiconductor layer configured to emit light of the first color,
the second sub-pixel includes a semiconductor layer configured to emit light of the first color, and a first color conversion layer stacked on the semiconductor layer of the second sub-pixel and excited by light of the first color from the second sub-pixel to emit light of the second color different from light of the first color, and
the third sub-pixel includes a semiconductor layer configured to emit light of the first color, and a second color conversion layer stacked on the semiconductor layer of the third sub-pixel and excited by light of the first color from the third sub-pixel to emit light of the third color different from light of the first color and the second color,
the first color conversion layer and the second color conversion layer respectively including quantum dots or nano phosphors.

13. The light-emitting diode as claimed in claim 1, wherein the second sub-pixel and the third sub-pixel are stacked on the first sub-pixel at an interval therebetween, and
light emitted from the first sub-pixel is projected into a space between the second sub-pixel and the third sub-pixel.

14. The light-emitting diode as claimed in claim 13, wherein the first sub-pixel includes:
a first transparent electrode layer stacked on a light-emitting surface of the first sub-pixel,
a distributed Bragg reflector (DBR) layer covering a side surface of the first sub-pixel and a portion of the first transparent electrode layer, and
an adhesive layer formed of a conductive metal material, disposed below the first sub-pixel, and metallurgically bonded to the metal pad, and
the second sub-pixel and the third sub-pixel are respectively stacked on the DBR layer.

15. The light-emitting diode as claimed in claim 14, wherein the second sub-pixel and the third sub-pixel respectively include an anode device electrode and a cathode device electrode, and
the cathode device electrode of the second sub-pixel and the cathode device electrode of the third sub-pixel are electrically connected to the metal pad, respectively.
